# EUROPEAN PATENT APPLICATION

(11) **EP 1 930 682 A1**
(43) Date of publication of application: **11.06.2008**
(21) Application number: 06797209.1
(22) Date of filing: 31.08.2006
(51) Int. Cl.: F28D 15/02, H01L 23/427

(54) **HEAT PIPE AND METHOD OF MANUFACTURING THE SAME**

(30) Priority: 01.09.2005 JP 2005253016; 05.12.2005 JP 2005350157; 31.01.2006 WO PCT/JP2006/030192
(71) Applicant: Fuchigami Micro Co.,Ltd., Kagoshima-shi, Kagoshima 891-0122 (JP)
(72) Inventor: OHSAWA, Kenji, Kagoshima-shi, Kagoshima 891-0122 (JP); TSURUTA, Katsuya, Kagoshima-shi Kagoshima 891-0122 (JP)
(74) Representative: Beetz & Partner
(86) International application number: PCT/JP2006/317249
(87) International publication number: WO 2007/026833

(57) **Abstract**

A small and thin heat pipe 1 with enhanced heat conductivity. Between an upper member 2 having a grid-like upper concave portion 21 on an inside lower surface and a lower member 3 having a grid-like lower concave portion 17 on an inside upper surface are provided intermediate plate members 7 and 8. The members 7, 8 are each formed with multiple vapor diffusion flow paths 10 extending in a planar direction, communicating with the concave portions 21, 17 of the members 2, 3, respectively. Thus, a sealed space is defined therebetween so that a refrigerant is enclosed therein. Capillary flow paths 11 are formed through a portion of the members 7, 8 except where the vapor diffusion flow paths 10 are formed such that the capillary flow paths 11 extend vertically or both vertically and horizontally, communicating with the concave portions 21,17 of the members 2,3.

## Description

### TECHNICAL FIELD

The invention relates to a heat pipe and a method for manufacturing the same, preferably is applicable to a thin and tabular heat pipe.

### BACKGROUND ART

Conventional heat pipes of this type have been disclosed for example in Japanese Un-examined Patent Publication Nos. 2002-039693 and 2004-077120.

The conventional heat pipes comprise: a container constituted by superimposing wall members on and below stacked partition plates each composed of a thin plate with slits (wig); and a refrigerant enclosed in a container interior space defined by the slits. Particularly, according to the technique described in Japanese Un-examined Patent Publication No. 2002-039693, the partition plates are stacked such that each slit is displaced in its widthwise direction.

Conventionally, formation of the container has been carried out by joining respective structure members of the container with one another at perimetric parts thereof.

Generally, enclosure of a refrigerant into a container interior space is carried out by providing a hole in a side surface, an upper surface or a lower surface of a heat pipe, charging a refrigerant into the container interior through the hole, and then closing the same by caulking or the like.

According to such conventional heat pipes, the heat pipe is constituted from thin and tabular components, and thus there is an advantage that a flat and thin heat pipe of so-called "flat type" can be provided. Furthermore, there is another advantage in that it has an excellent heat conductance due to a portion with which the slits are communicated serving as a flow passage for the refrigerant as well as a section where the slits are displaced serving as a movement passage through which the refrigerant is movable with the aid of a capillary phenomenon.
Patent Document 1 Japanese Un-Examined Patent Publication No. 2002-039693
Patent Document 2 Japanese Un-Examined Patent Publication No. 2004-077120

### DISCLOSURE OF THE INVENTION

### PROBLEMS TO BE SOLVED BY THE INVENTION

Although the above-mentioned heat pipes have an advantage that heat conductance can be enhanced despite their thin and tabular shapes, it is desirable to enhance heat conductance further while keeping the heat pipes thin in shape, in order to effectively cool CPU (Central Processing Unit) or the like that emits a large amount of heat due to being operated at high speed at all times

The present invention has been made in view of the above-mentioned. It is, therefore, an object of the present invention to provide a small-sized and thin heat pipe that enables further improvement of heat conductance by improving the liquid circulation property.

It is another object of the present invention to provide a small-sized and thin heat pipe that enables further improvement of heat conductance, by improving the heat dissipation effect.

It is a further object of the present invention to provide a small-sized and thin heat pipe that enables further improvement of heat conductance, by drawing the heat from an object to be cooled directly into the heat pipe.

Also, it is a further object of the present invention to provide a heat pipe that enables the prevention of the life-shortening due to internal corrosion, by decreasing outgassing concentration.

Still also, it is a further object of the invention to provide a heat pipe that is capable of enhancing heat resistance and reliability by preventing the heat pipe from being deformed or damaged by thermal expansion of a refrigerant.

In addition to the foregoing, it is a still further object of the present invention to provide a heat pipe with such an enhanced productivity that the price-reduction of a heat pipe is attained, while preventing the flatness of the outer surface of the heat pipe from being impaired by a sealing member.

### MEANS FOR SOLVING THE PROBLEMS

According to an aspect of the present invention, there is provided a heat pipe comprising:
an upper member, said upper member being tabular, having a concave portion on a lower surface;
a lower member, said lower member also being tabular, having a concave portion on an upper surface;
one or more intermediate plate members, said one or more intermediate plate members being tabular, provided between said upper member and said lower member, each intermediate plate member including a plurality of vapor diffusion flow paths extending in a planar direction, communicating with the concave portions of said upper and lower members to form a sealed space defined by said upper and lower members with said vapor diffusion flow paths and said concave portions being included therein;
a refrigerant enclosed in said sealed space; and
capillary flow paths formed through a portion of said one or more intermediate plate members except where said vapor diffusion flow paths are formed, said capillary flow paths extending vertically or both vertically and horizontally, communicating with the concave portions of said upper and lower members.

In the heat pipe of the foregoing structure, it is preferable that said intermediate plate members are more than one, each intermediate plate member having a through-hole formed therethrough, such that the through-holes of said intermediate plate members are overlapped only partially by stacking said intermediate plate members to define said capillary flow paths each having a planar cross-sectional area narrower than that of said through-hole.

It is also preferable that the heat pipe may further comprise a plurality of projections integrally formed on an outer surface of at least one of said upper and lower members so that a device to be cooled may be mounted thereon.

Preferably, in the heat pipe of the foregoing structure, said upper and lower members may have a rectangular planar shape, respectively, while a device mounting section for mounting a device to be cooled thereon is arranged in the center of said heat pipe, with each of said vapor diffusion flow paths extending in an oblique direction relative to sides of said heat pipe.

Further, it is preferable that said upper and lower members have a rectangular planar shape, respectively, while a device mounting section for mounting a device to be cooled thereon is arranged in the center of said heat pipe, with each of said vapor diffusion flow paths extending in a radial direction from said device mounting section.

Still further, it is preferable that joining projections are formed in a peripheral portion of each of said upper member, one or more intermediate plate members and lower member as well as from a peripheral portion of said device mounting section to a neighborhood thereof, so that said upper member, one or more intermediate plate members and lower member are joined directly to each other by hot pressing to said joining projections.

A method for manufacturing a heat pipe according to another aspect of the present invention comprises the steps of:
preparing a lower member of a tabular shape, having a concave portion on an upper surface thereof; an upper member of a tabular shape, having a concave portion on a lower surface thereof; and one or more intermediate plate members provided between said upper member and said lower member, each intermediate plate member being of a tabular shape, including a plurality of vapor diffusion flow paths extending in a planar direction, communicating with the concave portions of said upper and lower members;
superimposing said members with one upon top of another;
applying hot pressing to joining projections, said joining projections being formed either in peripheral portions of said lower, upper and one or more intermediate plate members where said members are to be joined directly to each other, or in peripheral portions of said lower, upper and one or more intermediate plate members as well as from a peripheral portion of said device mounting section to a neighborhood thereof; and
joining said upper, lower and one or more intermediate plate members together directly relative to each other in positions where said joining projections are formed.

In the foregoing method, it is preferable that the heat pipe may comprise:
an upper member, said upper member being tabular, having a concave portion on a lower surface;
a lower member, said upper member being tabular, having a concave portion on an upper surface;
one or more intermediate plate members, said one or more intermediate plate members being tabular, provided between said upper member and said lower member, each intermediate plate member including a plurality of vapor diffusion paths, communicating with the concave portions of said upper and lower members, said respective members being superimposed with one upon top of another to form a sealed space defined by said upper and lower members with said vapor diffusion flow paths and said concave portions being included therein;
one or more refrigerant charging openings formed through one of said upper and lower members, said refrigerant charging openings allowing said sealed space to communicate with an exterior space;
a refrigerant enclosed in said sealed space; and
a sealing plug for sealing each of said refrigerant charging openings, said sealing plug being made from ductile metal.

Preferably, the heat pipe may further comprise one or more degassing grooves formed on a peripheral inner surface of each of said refrigerant charging openings, wherein said degassing groove keeps an interior space communicated with an exterior space until each refrigerant charging opening is sealed fully by said sealing plug, while said degassing groove is sealed by said sealing plug when each refrigerant charging opening is sealed fully by said sealing plug.

Also, it is preferable that each refrigerant charging opening has a larger diameter in an upper portion thereof than in a lower portion thereof, while a surface of said sealing plug for sealing each refrigerant charging opening is not protruded from an outer surface of the member formed with said refrigerant charging opening.

Still also, it is preferable that an interior of said sealed space is under reduced pressure.

A method for manufacturing a heat pipe according to another aspect may comprise the steps of:
preparing a lower member of a tabular shape, having a concave portion on an upper surface thereof; an upper member of a tabular shape, having a concave portion on a lower surface thereof; and one or more intermediate plate members provided between said upper member and said lower member, each intermediate plate member being of a tabular shape, including a plurality of vapor diffusion flow paths extending in a planar direction, communicating with the concave portions of said upper and lower members;
superimposing said members with one upon top of another;
applying hot pressing to joining projections, said joining projections being formed either in peripheral portions of said lower, upper and one or more intermediate plate members where said members are to be joined directly to each other, or in peripheral portions of said lower, upper and one or more intermediate plate members as well as from a peripheral portion of said device mounting section to a neighborhood thereof;
joining said upper, lower and one or more intermediate plate members together directly relative to each other in positions where said joining projections are formed;
supplying a refrigerant into a sealed space defined by said upper and lower members through one or more refrigerant charging openings formed through at least one of said upper and lower members, under reduced pressure; and
placing a ductile metallic body serving as a sealing plug in each refrigerant charging opening, and then applying pressure to said ductile metallic body to thereby provide said sealing plug for sealing each refrigerant charging opening.

### EFFECT OF THE INVENTION

According to a heat pipe of the present invention, vapor diffusion flow paths extending in a planer direction and communicating with the concave portions of the upper and lower members are formed through the one or more intermediate plate members, while the capillary flow paths extending vertically or both vertically and horizontally, communicating with the concave portions of the upper and lower members are formed. Accordingly, the circulation of a refrigerant is facilitated due to the diffusion of vapor by the vapor diffusion flow paths as well as the return of the refrigerant by the capillary flow paths, thus improving fluid circulation characteristic, thus enabling the provision of a small and thin heat pipe capable of further improving the heat conduction property as compared to the conventional ones.

Specifically, more capillary flow paths are provided in portions of the intermediate plate members except where the vapor diffusion flow paths are formed, it is possible to make substantially entire areas of the heat pipe contribute to the heat conduction, thus enabling the noticeable enhancement of the heat conduction effect.

According to the heat pipe of the above structure, the respective through-holes of the multiple intermediate plate members are overlapped only partially to define the capillary flow paths, thus enabling a planar cross-sectional area of each capillary flow path to be narrower than that of each through-hole of the respective intermediate plate members. Thus, the fluid circulation caused by the vapor diffusion action and the fluid circulation caused by the capillary phenomenon are allowed to be well-balanced, thus making it possible to maximize and optimize the heat conduction effect eventually.

This, in other words, means that the present invention enables the formation of such narrow (or minute) capillary flow paths that go beyond the limit of miniaturization techniques for miniaturizing the through-holes of the intermediate plate member.

Further, a plurality of the projections for mounting a device to be cooled thereon are integrally formed on the outside surface of at least one of the upper and lower members, and those projections are allowed to come in direct contact with the device to be cooled, thus enabling further enhancement of the cooling effect against the device to be cooled. Accordingly, it is possible to provide a small and thin heat pipe that can realize the still further improvement of the heat conduction property as compared to the conventional ones. Thus, even for a high-speed CPU (Central Processing Unit) of 5GHz level with a high heating value, for example, there can be provided an optimal heat pipe whose heat dissipation effect is so high that even such CPU can be cooled reliably.

This is due to the fact that when a bottom surface of a device to be cooled is attached to a certain flat surface such as that of a conventional heat pipe, adhesive having an extremely large heat transfer resistance is present therebetween, which makes it difficult to enhance the heat conductance. Therefore, it is not rare that full heat dissipation ability required for an electronic device to be cooled such as CPU is unable to be obtained when CPU has such a large heat release value that it requires stronger heat dissipation effect.

According to the heat pipe of the present invention, however, multiple projections are provided on a portion on which a device to be cooled is to be placed, while the device to be cooled can be fixed to the heat pipe by the adhesive provided in clearances between those multiple projections. Accordingly, each projection is allowed to come in direct contact with the device to be cooled, thus enabling the heat from the device to be cooled to be transferred to the heat pipe, with the use of the adhesive reduced to minimum.

Also, said upper and lower members have a rectangular planar shape, respectively, while a device to be cooled is placed in the center of the heat pipe, with each of said vapor diffusion flow paths extending either in an oblique direction relative to sides of said heat pipe or in a radial direction from the center, whereby effective heat dissipation from the center toward the corners of the heat pipe is realized, thus enabling substantially the entire area of the heat pipe including its corners to contribute to heat dissipation, thereby attaining further enhancement of the heat conduction effect.

According to the heat pipe of the present invention, joining projections are formed not only in a peripheral portion of each of said upper member, one or more intermediate plate members and lower member, but also from a peripheral portion of said device mounting section to a neighborhood thereof, so that those members are joined directly to each other by hot pressing to said joining projections. Thus, deformation or damage of the heat pipe caused by the thermal expansion of refrigerant can be prevented, to thereby enhance the heat resistance and reliability of the heat pipe. Besides, since the heat pipe of the invention is less likely to be deformed or damaged, a long-life heat pipe can be obtained.

According to the method for manufacturing the heat pipe of the present invention, hot pressing is applied to the joining projections formed either in peripheral portions of said members where said members are to be joined directly to each other, or not only in those peripheral portions but also from a peripheral portion of said device mounting section to a neighborhood thereof. Accordingly, heat and pressure are allowed to be concentrated on the portions where said joining projections are formed so that said members are directly joined together in the portions where said joining projections are formed. As a result, the joining process essential for integration of the members into a heat pipe can be performed without the need for welding material, bonding material and the like.

Therefore, since no impurities derived from the welding or bonding material are allowed to be mixed into a heat pipe, there can be provided a heat pipe that can be prevented from getting short-lived due to internal corrosion. Furthermore, since a heat pipe can be manufactured more simply and quickly without using any expensive bonding material such as silver brazing material, price-reduction of heat pipes can be attained.

According to the heat pipe and its manufacturing method of the present invention, ductile metal is placed on the refrigerant charging opening of each of the two or more heat pipes, and then pressure and heating are applied thereto at the same time, thus enabling the ductile metal to be brought into plastic flow, whereby simultaneous sealed enclosure of the refrigerant can be carried out all at once. As a result, mass-productivity of a heat pipe can be enhanced, leading to price reduction, as compared to the conventional sealing method in which caulking is carried out one by one for each refrigerant charging opening.

Moreover, at the time of sealing the refrigerant charging opening with the ductile metal, vacuum deaeration is performed through the degassing grooves, and thus, even though some hazardous component that causes the inside of the heat pipe to corrode exists in the interior space, the air in the interior space is removed through the degassing grooves, thus enabling the hazardous component and the air to be removed from the internal space reliably. As a result, there can be provided a heat pipe with a reduced outgassing concentration, preventing the life-shortening caused by internal corrosion.

Still further, each refrigerant charging opening is formed to have a larger diameter in an upper portion thereof than in a lower portion thereof, and thus the remainder of the ductile metal that has fully filled in the smaller lower portion is accommodated within the larger upper portion, thus enabling the remainder thereof to be prevented from protruding out of the outside surface of the heat pipe.

As a result, it is possible to prevent any projection that may impair the flatness of the heat pipe from being produced by the sealing process.

Moreover, if the sealed space after the sealing process is under a reduced pressure, then the boiling point of the refrigerant will drop, and thus the refrigerant that draws heat from a device to be cooled is allowed to be circulated at a temperature slightly higher than a normal temperature due to the vapor diffusion through the vapor diffusion flow paths and the return of the refrigerant through the capillary flow paths, thereby improving the heat dissipating effect. As a result, there can be provided a small and thin heat pipe with further enhanced heat conductance as compared to the conventional ones.

### BRIEF DESCRIPTION OF THE DRAWINGS

Fig. 1 is a perspective view showing respective outline structures of upper and lower members of a heat pipe in accordance with a first embodiment of the invention.
Fig. 2 is an exploded perspective view showing respective outline structures of the upper member, upper and lower intermediate plate members and the lower member taken on line A-A' of Fig.1.
Fig. 3(A) is a partially cutaway plan view showing the integrated structure of the upper member, the upper and lower intermediate plate members and the lower member taken on line A-A', while Fig.3(B) is a schematic section taken on line B-B' thereof.
Fig. 4 is a perspective view seen from below, showing an outline structure of a lower surface of the lower member taken on line A-A'.
Fig. 5(A) is a schematic diagram showing a lower inside surface of the upper member, respective upper structures of the upper and lower intermediate plate members, and an upper inside surface of the lower member, respectively, while Fig. 5(B) is a schematic diagram showing the upper and lower intermediate plate members and the lower member being superimposed.
Fig. 6 is a schematic diagram showing how the through-holes of the upper and lower intermediate plate members are arranged.
Fig. 7 is a schematic diagram showing a detailed structure in which the upper and lower intermediate plate members and the lower member are superimposed.
Fig. 8 shows steps (A) to (E) illustrated in the order of manufacturing steps in accordance with as an example of the manufacturing method of the heat pipe according to the first embodiment, in which (A), (B), (D), and (E) are cross-sectional views, while (C) a top plan view of the opening seen from above.
Fig. 9 is a plane cross-sectional view showing the structure of a refrigerant charging hole and an air outlet port in the upper member.
Fig. 10 is an explanatory section illustrating the principle of a refrigerant circulating phenomenon within a sealed space of the heat pipe.
Fig. 11 is a detailed sectional side view illustrating the circulating phenomenon of the refrigerant passing through vapor diffusion flow paths and capillary flow paths.
Fig. 12 is an outline view showing the vapor diffusion flow paths in the heat pipe according to the second embodiment of the invention.
Fig. 13 is a schematic diagram showing a simulation result on the heat spreading property, said simulation having been performed on the heat pipe of the invention and a simple copper plate.
Fig. 14 shows graphs showing respective temperature distributions in copper plates and the heat pipes of the invention each having different thickness, as a result of a test on the heat spreading property thereof.
Fig. 15 is a cross-sectional view showing the side sectional structure of the upper member, the upper and lower intermediate plate members and the lower member of the heat pipe according to the third embodiment of the invention.
Fig. 16 is a schematic diagram showing an outline structure of the lower intermediate plate member, a side sectional structure thereof, and an outline structure of a central projection of the intermediate plate member formed in a central capillary formation region.
Fig. 17 is a schematic diagram showing an outline structure of the intermediate plate member in accordance with a modified example of the third embodiment.
Fig. 18(A) and (B) are perspective views showing the outline structure of the upper and lower outside surfaces of the heat pipe in accordance with the fourth embodiment of the invention, respectively.
Figs. 19(A) to (C) are cross-sectional views showing manufacturing steps in sequence, as a first example of the manufacturing method of the heat pipe according to the fourth embodiment of the invention.
Fig. 20 is a schematic diagram showing an overall structure of an upper inside surface of the lower member.
Fig. 21 is a schematic diagram showing an overall structure of a lower inside surface of the upper member.
Figs. 22(A) to (C) are cross-sectional views showing manufacturing steps in sequence, as a second example of the manufacturing method of the heat pipe according to the fourth embodiment of the invention.
Fig. 23(A) is a plan view of the refrigerant charging hole formed in the upper member, while Fig. 23(B) is a section thereof.
Fig. 24(A) is a plan view showing either the refrigerant charging hole or the air outlet port in accordance with a first example, Fig. 24(B) a side sectional view thereof, and Fig. 24(C) a side sectional view thereof illustrating the hole or the outlet port being sealed by the sealing member.
Fig. 25(A) is a plan view showing either the refrigerant charging hole or the air outlet port in accordance with a second example, Fig. 25(B) a side sectional view thereof, and Fig. 25(C) a side sectional view thereof, illustrating the hole or outlet being sealed by the sealing member.

### BEST MODE FOR CARRYING OUT THE INVENTION

The heat pipe of the present invention basically comprises an upper member, a lower member, and one or more intermediate plate members formed with vapor diffusion flow paths and vertical (or both vertical and horizontal) capillary flow paths. For the material of those upper and lower members and intermediate plate members, copper is optimal since it has high heat conductance.

A device to be cooled by the heat pipe, such as IC (semiconductor integrated circuit), LSI (large-scale integrated circuit), CPU or the like is set in an device mounting section provided on a certain part of either one of the upper and lower members, e.g., in the center of the outer (i.e., lower) surface of the lower member. In the case of the device whose heat discharge is large, such as CPU, the device mounting section may be provided with projections formed integrally therewith.

In other words, it becomes possible to transfer heat from the device to be cooled promptly to the heat pipe side, without transferring the heat via an adhesive, with the device to be cooled being fixedly mounted to a desired position on the device mounting section, by allowing the projections to come in direct contact with the device to be cooled with the adhesive being placed in clearances between the projections.

In the case that the upper and lower members that make up an contour of the heat pipe have a rectangular planar shape, the vapor diffusion flow paths may be parallel to either long or short side of the heat pipe. More preferably, they may be extended obliquely thereto. That is because the vapor diffusion flow paths extended obliquely enable effective heat dissipation toward corners of the heat pipe, as contrasted to the fact that the ones parallel to the long or short side of the heat pipe do not enable effective heat dissipation from the center of the heat pipe toward the outside thereof.

Specifically in the case that the vapor diffusion flow paths are formed radially from the device to be cooled, heat can be efficiently dissipated entirely and uniformly from the center of the heat pipe where the device to be cooled is placed to the perimetric portion thereof including all of four corners thereof. Accordingly, the heat-conduction effect can be enhanced, thus providing an optimal heat pipe.

In the case where the number of the intermediate plate members is more than one, there appears a region where slits for vapor diffusion flow paths of the respective intermediate plate members are overlapped with one another, thus defining a wide region communicating with the concave portions of the upper and lower members to thereby form flow paths for flowing vaporized refrigerant in a planar direction (hereinafter called vapor diffusion flow paths). In the meantime, in the case that only one intermediate plate member is used, the aforesaid slit for vapor diffusion flow path becomes the vapor diffusion flow path itself.

The vapor diffusion flow paths may be formed in a band shape, trapezoid shape, or otherwise, may be gradually widened or narrowed from the center toward the perimeter. It should be noted, however, that the vapor diffusion flow paths may take any other suitable shape.

In the case where the two or more intermediate plate members are provided, the overlapped vapor diffusion flow paths may be completely superimposed with respect to one another, or otherwise, they may be displaced in the width direction. In the hereinbelow-described embodiments, the intermediate plate members are laid on top of another so that the slits for the vapor diffusion flow paths are not displaced in the width direction.

Also, in the case where the two or more intermediate plate members are provided, certain flow paths (hereinafter called capillary flow paths) for flowing the refrigerant toward the vertical or both vertical and horizontal directions are formed by superimposing those intermediate plate members, said capillary flow paths being defined by the superimposed through-holes, communicating with the concave portions of the upper and lower members.

In the meantime, the through-holes of the respective intermediate plate members may or may not be formed in the same pattern. When only one intermediate plate member is used, the through-holes themselves serve as capillary flow paths.

In other words, those intermediate plate members may be provided between the upper and lower members such that the positions, shapes and sizes of the through-holes of the respective intermediate plate members may coincide to thereby construct capillary flow paths having the same position, shape and size as the through-hole of each intermediate plate member.

In that case, the through-hole or the resultant capillary flow path may have a rectangular shape (for example, square or oblong shape), of which the corners may be rounded. Although it is to be of a rectangular shape fundamentally, a part or whole side thereof (i.e., peripheral inner surface of the capillary flow path) may be corrugated or wrinkled so as to enlarge a surface area thereof, because a cooling effect is enhanced if the peripheral inner surface area of the capillary flow path is large. Alternatively, the capillary flow path may take a hexagonal, circular or elliptical shape.

However, in order to form the capillary flow path with a smaller cross-sectional area as seen from a direction parallel to the flat surfaces of the tabular upper and lower members, the two or more intermediate plate members may be suitably displaced from the positions where the respective through-holes are precisely aligned with one another so as to be only partially overlapped, thereby enabling the substantive cross-sectional area of the capillary flow path to be made small as compared with the cross-sectional area of the through-hole of each intermediate plate member.

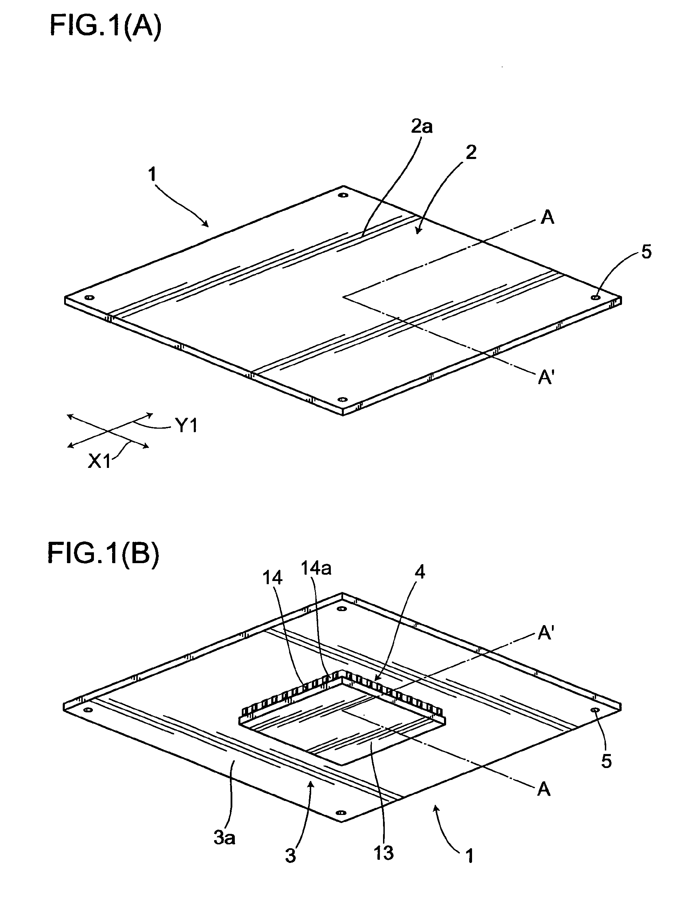

More specifically, when the two intermediate plate members are used, it is possible to reduce the substantive cross-sectional area of the capillary flow path to about 1/2 of that of the through-hole of each intermediate plate member, by displacing the respective intermediate plate members by a half pitch of an arrangement pitch in a predetermined direction (e.g., lateral direction, i.e., hereinafter described X1 direction in Fig.1(A)), with the size, shape and arrangement pitch of each through-hole being kept the same.

Furthermore, if the positions of the through-holes of the two intermediate plate members are also displaced in a direction intersecting with the foregoing direction (for example, longitudinal direction. i.e., hereinafter described Y1 direction in Fig. 1(A)), the substantial cross-sectional area of the capillary flow path can be reduced to about 1/4 of that of the through-hole of each intermediate plate member.

When the through-holes are displaced in the respective intermediate plate members, then the capillary flow paths are formed such that a refrigerant flows not only in the vertical direction but also in the horizontal or planar direction.

Although the concave portions of the upper and lower members are formed in a grid pattern partitioned by projecting poles in the hereinbelow described embodiment, they may be formed in a different pattern than such grid pattern, such as a mesh pattern. In response to such pattern, the projecting poles are formed such that the transverse section thereof may be formed in a square, circular, elliptical, polygonal, or a star shape. The upper and lower-members are each formed to 500-2,000µm thickness, while the depth of each concave portion (namely, height of the projecting pole) is in a range from 100 to 1000µm. Furthermore, the thickness of the intermediate plate member is in a range from 50 to 500µm.

In the manufacture of the heat pipe of the invention, the upper member, the intermediate plate members and the lower member may be produced separately such that they are formed with the joining projections on at least one of opposite portions of the adjacent members that are to be subjected to direct joining, which may be formed into a single piece by hot press after suitable position adjustment, thereby completing all manufacturing steps except the step for filling refrigerant.

The term "direct joining" referred to herein means to strongly bond atoms to each other by atomic force acting upon between first and second surfaces to be joined together, by applying heat treatment while applying pressure with the first and second surfaces to be joined together. Thus, it is possible to integrate the first surface with the second without using adhesive or the like.

The joining protrusions in that case are formed in the perimeter(s) of the upper member or the intermediate plate members in a frame pattern, for example. Then, a predetermined amount of refrigerant is charged through two charging openings (one for refrigerant charging hole, the other for air outlet port) formed on a part of the heat pipe (e.g., on the upper or lower member) under reduced pressure (e.g., under vacuum). Then, the refrigerant charging openings (one is a refrigerant charging hole, the other is an air outlet port) are sealed with a ductile metal, thus completing the heat pipe of the present invention.

As for conditions for the aforesaid direct joining by heat (hot) press, it is preferable that the pressing pressure is in a range of from 40 to 150kg/cm², and a temperature in a range from 250 to 400 degrees C. As for the amount of the refrigerant to be charged into, it is desirable that it is substantially equal to a total volume of the through-holes in the case of water, for example.

In the foregoing heat pipe, the joining projections are formed in a peripheral portion of each of the upper member, intermediate plate members and lower member as well as from a peripheral portion of the device mounting section to a neighborhood thereof, so that the upper member, intermediate plate members and lower member are joined directly to each other by hot pressing. As a result, the integration of the members by the direct joining is realized even from the peripheral portion of the device mounting section to the neighborhood thereof, and thus it is possible to prevent the deformation or damage of the heat pipe due to the thermal expansion of the refrigerant, thus enhancing the heat resistance and reliability of the heat pipe. Also, the heat pipe of the invention can enjoy a prolonged service life thereof, since it is less likely to be deformed or damaged.

That is, according to the foregoing heat pipe, it is possible to prevent such a phenomenon that the heat pipe tends to be expanded toward the outside nearly in the center thereof due to the thermal expansion of the refrigerant caused by the temperature rise of the refrigerant by the heat generated from the device to be cooled (hereinafter called "Popcorn phenomenon"). The number of the joining protrusions formed in the peripheral portion of the device mounting section or its neighborhood, may be one or more, and they may take a square pillar shape (inclusive of square and rectangular parallelepiped), a cylindrical or elliptic pillar shape.

In the meantime, sealing can be performed by for example, the following highly mass-productive method as well:

In that case, in the heat pipe where the lower member, the intermediate plate members, and the upper member are directly joined together by hot press (the heat pipe being not completed yet at that stage), either one of the upper and the lower members may be provided with for example a pair of the refrigerant charging openings (one for refrigerant charging hole, the other for air outlet port, but only one refrigerant charging opening may be provided). Then, a predetermined amount of the refrigerant is filled in the internal sealed space (which is not sealed yet at that stage) at atmospheric pressure. Subsequently, ductile metal, such as a solder, is placed on each refrigerant charging opening.

Under that condition, vacuum deaeration (at 0.5KPa, for example) is performed for about e.g., 10 minutes by pressure reduction through degassing grooves under a low temperature condition (from 0 degree C to normal temperature (for example, about 25 degrees C)), and then under that low temperature state, the sealing member is pressed (e.g., at 10-80kg/cm²) from above by a press for several minutes so that it is subjected to low temperature pressure deformation. Thus, the refrigerant charging openings are temporarily sealed by carrying out such low-temperature vacuum pressurization treatment. At that time, the refrigerant charging openings are closed by the ductile metal.

Next, after the low-temperature vacuum heating treatment, the ductile metal is further pressed from above (at 30-150kg/cm²) for about 10 minutes under a high temperature condition (from normal temperature (e.g., about 25 degrees C) to 180 degrees C), with a degree of vacuum being set to 0.5KPa, for example. As a result, the ductile metal is turned into plastic flow, and subjected to high-temperature pressurization deformation so that the refrigerant charging openings are still more firmly closed by the ductile metal.

According to the foregoing manufacturing method of a heat pipe, with the ductile metal being placed on the refrigerant charging opening of each heat pipe, the pressing and heating of the ductile metal can be carried out against the two or more heat pipes at a time, so that the enclosure of the refrigerant can be carried out at the same time, with all the ductile metals being brought into plastic flow. Accordingly, as compared with the conventional sealing method in which a separate caulking work would need to be performed per each refrigerant charging opening, the method of the invention enables the sealing work to be performed at a time and on a plane, so that the sealing work of a heat pipe can be performed more simply, thus enhancing the mass-production property of a heat pipe, eventually leading to price reduction of the heat pipe.

Moreover, as for the configuration of a pair of the refrigerant charging openings, one of them (for example, the refrigerant charging hole) may be positioned at one corner of the rectangular heat pipe, while the other (for example, air outlet port) may be positioned at the opposing corner, thus making it easy to supply the refrigerant into the whole interior of the heat pipe.

Moreover, since the sealed space after the sealing process is brought under a reduced pressure lower than the atmospheric pressure, the boiling point of a refrigerant will drop, and thus the refrigerant that draws heat from a device to be cooled is allowed to be vaporized at a temperature slightly higher than a normal temperature so that it is diffused in the vapor diffusion flow paths, thus enabling the heat of the heat pipe to be homogenized over an entire portion of thereof. In the meantime, the pressure inside the sealed pace in that case is preferably within a range of from 0.3 to 0.8 KPa.

Still moreover, the refrigerant charging opening may be shaped such that a top portion thereof has a larger diameter than a bottom portion thereof, and thus a remainder of the ductile metallic body that has fully filled the smaller bottom portion is allowed to be appropriately accommodated within the larger top portion, thereby enabling the same to be prevented from protruding from the outside surface of the heat pipe.

As a result, it is possible to prevent any projection that may impair the flatness of the heat pipe from being produced by the sealing process.

In the meantime, materials having good heat conductance, such as copper, copper alloy, aluminum, aluminum alloy, iron, iron alloy, stainless steel, etc. are suitable for the upper member, intermediate plate member(s), and lower member that make up the body of the heat pipe, while water (pure water, distilled water, etc.), ethanol, methanol, acetone, etc. are suitable for the refrigerant.

### First Embodiment

Next is a detailed description of the present invention with reference to the accompanying drawings.

Figs. 1 (A) and (B) show the outline structures of the upper and lower surfaces of a heat pipe 1 in accordance with a first embodiment of the invention. The heat pipe 1 comprises an upper member 2 and a lower member 3 formed from a highly heat conductive material such as copper. On a device mounting section 4 provided in the center of the lower outside surface 3a of the lower member 3 can be mounted a device to be cooled 13, such as IC (semiconductor integrated circuit), LSI (large scale integration circuit), CPU, etc.

The upper member 2 and the lower member 3 are each tabular, formed in a rectangular (square) shape in a plan view, including no irregularities on an upper outside surface 2a thereof so that a degree of freedom may be improved when mounting the same to the inside of a mobile or small device. Moreover, a positioning hole 5 is formed through four corners thereof, respectively so that the upper member 2 and the lower member 3 are positioned based on the positioning holes 5, and then they are superimposed so as to be directly joined to each other.

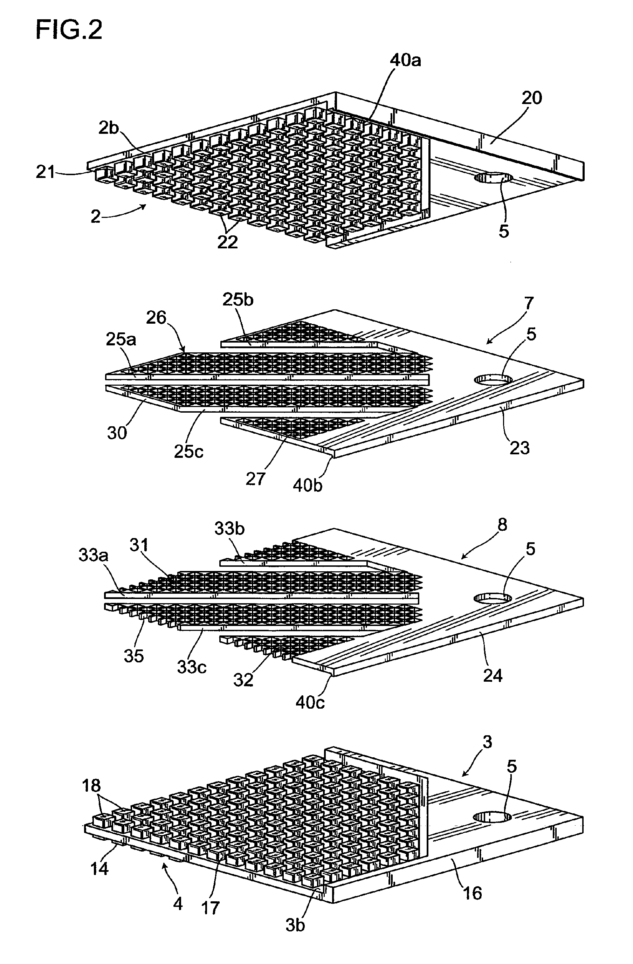

Fig. 2 is an exploded perspective view showing respective outline structures of the upper member 2, upper and lower intermediate plate members 7,8 and the lower member 3 taken on line A-A' of Fig.1.

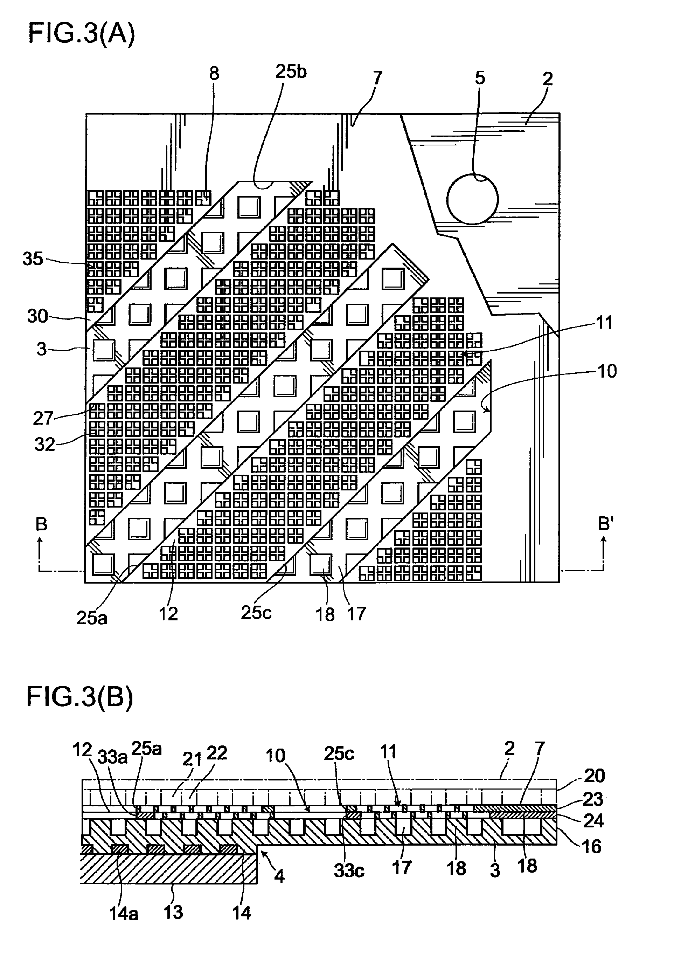

Between the upper member 2 and the lower member 3 of the heat pipe 1 are provided the upper intermediate plate member 7 and the lower intermediate plate member 8 that are superimposed in that order while being properly positioned based on the positioning hole 5, respectively. Fig. 3(A) is a partially cutaway plan view showing the integrated structure of the upper member, the upper and lower intermediate plate members and the lower member, while Fig. 3(B) is a schematic section taken on line B-B' of Fig. 3(A). As shown in Figs. 3 (A) and 3(B), vapor diffusion flow paths 10 and capillary flow paths 11 are formed by these upper and lower intermediate plate members 7 and 8.

A predetermined amount of a refrigerant made of water (not shown) is enclosed in a sealed space 12 of the heat pipe 1 under reduced pressure so that the refrigerant is capable of being circulated through the vapor diffusion flow paths 10 and the capillary flow paths 11 due to the heat from the device to be cooled 13.

In practice, according to the heat pipe 1, the refrigerant is warmed by the heat from the device to be cooled 13 and evaporates, so that the vapor is allowed to diffuse toward the peripheral portions through the two or more vapor diffusion flow paths 10 extending in a planar direction parallel to a direction defined from one corner to the opposite corner arranged in a diagonal line (i.e., X1 direction in Fig. 1 parallel to flat surfaces of the flat upper and lower members 2, 3 as well as Y1 direction in Fig. 1 parallel to the said flat surfaces and orthogonal to the direction X1).

At the same time, the refrigerant liquefied due to heat loss and condensation at the peripheral portion side is allowed to pass through the capillary flow paths 11 extending in a vertical direction (i.e., a direction orthogonal to both the X1 and Y1 directions) and the concave portion 17 arranged in a grid pattern (hereafter called grid-patterned lower member concave portion), having a predetermined depth, formed on the upper inside surface 3b of the lower member 3, so that the refrigerant is returned again to the central side of the heat pipe. In this way, the above-mentioned refrigerant circulating phenomenon is continuously and successively repeated.

Accordingly, in the heat pipe 1, heat is drawn from the device to be cooled 13 due to the latent heat at the time of the evaporation of the refrigerant, and thus it is possible to effectively cool the device to be cooled 13 by the heat dissipation on the entire surface of the upper member 2, part of the lower member 3 except the device mounting section 4, and the vapor diffusion flow paths 10.

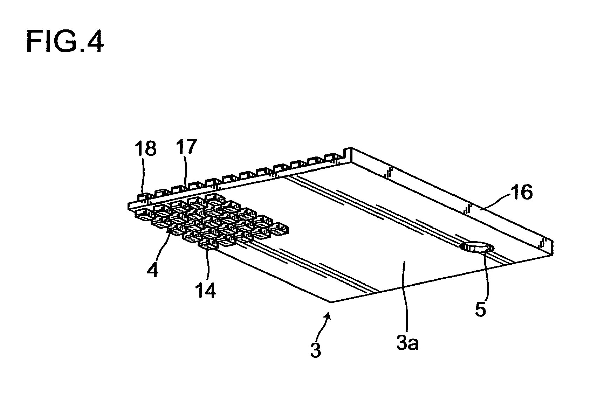

In the meantime, the device mounting section 4 (see Fig. 1 (B)) provided on the central part of the lower outside surface 3a of the lower member 3 is formed according to a shape (substantially square shape in this case) of the device to be cooled 13. As shown in Fig. 4 showing the structure of the lower member 3 taken on A-A' sectional line of Fig. 1 (B), two or more projections 14 each having a small area are provided, corresponding to the contour of the device to be cooled 13.

In the present embodiment, each projection 14 is of a square pillar shape, having a distal end surface of from 50 to 300 µm square, and arranged regularly at equal intervals (500-1,000 µm pitch in this case) in the device mounting section 4 of 15,000 µm square.

Adhesive resin 14a, such as epoxy resin or silicone-based adhesive resin, is provided in a clearance where no projections 14 are formed on the device mounting section 4 so that the device to be cooled 13 is bonded to the adhesive resin 14a. Thus, the device to be cooled 13 can be provided so as to come in direct and close contact with the distal end surfaces of the projections 14, without the presence of the adhesive therebetween.

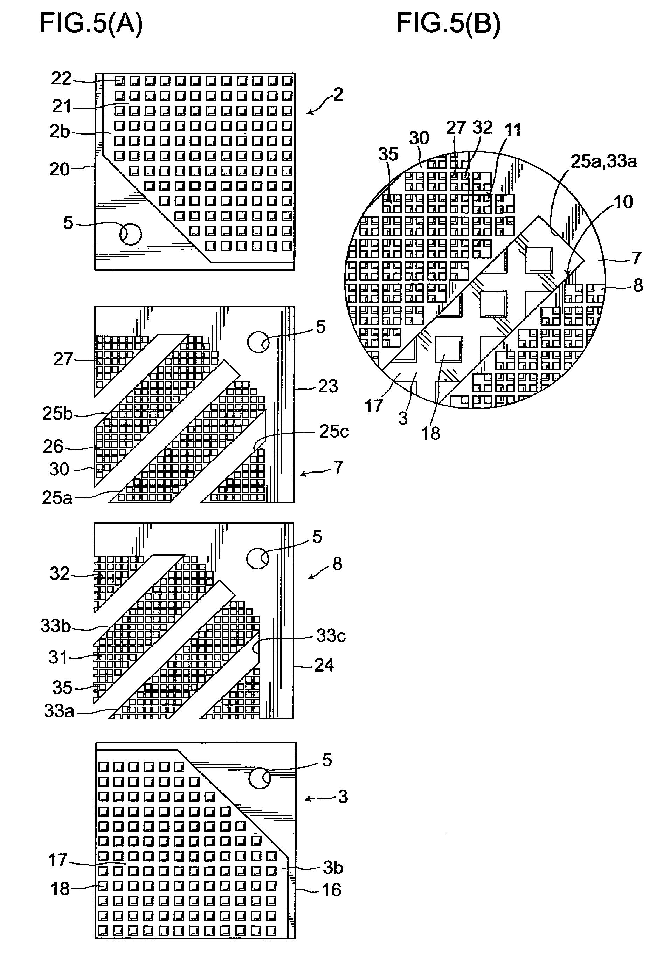

Fig. 5(A) is a schematic diagram showing the surface structure of the upper member, the upper and lower intermediate plate members, and the lower member, taken on A-A' line of Fig.1, while Fig. 5(B) illustrates the upper and lower intermediate plate members and the lower member being superimposed.

As shown in Fig. 5 (A), the lower member 3 is formed with the aforesaid grid-patterned lower member concave portion 17 except the perimeter of the positioning hole 5 formed through the corner, and the peripheral portion 16 defining a contour of the heat pipe. Respective areas demarcated by the grid-patterned concave portion 17 are provided with projecting poles 18 each having a flat end face. In the present embodiment, the thickness of the lower member 3 is about 800 µm, and the grid-patterned concave portion 17 of about 200 µm depth is formed on the upper inside surface 3b of the lower member 3.

On the other hand, the upper member 2 is formed with another grid-patterned concave portion 21 arranged in a grid pattern (hereafter called grid-patterned upper member concave portion), having a predetermined depth, formed on an entire surface of the lower inside surface 2b of the upper member 2, except the perimeter of the positioning hole 5 formed through the corner and the peripheral portion 20 defining a contour of the heat pipe. Respective areas demarcated by the grid-patterned upper member concave portion 20 are provided with projecting poles 22 each having a flat end face.

In the present embodiment, the upper member 2 is formed to have the same shape and size as the lower member 3, and the thickness thereof is set at about 800 µm, and the grid-patterned upper member concave portion 21 of about 200 µm depth is formed on the lower inside surface 2b of the upper member 2, while the projecting poles 22 each having a square pole shape with a flat end face, are arranged regularly on the lower inside surface 2b.

The upper intermediate plate member 7 and the lower intermediate plate member 8 are each formed tabular, having a thickness of about 100 µm, made from a highly heat conductive material such as copper. They are formed so as to have the same contour as the upper member 2 and the lower member 3 so that the peripheral portions 23 and 24 thereof may coincide with the peripheral portions 16 and 20 of the upper and lower members 2 and 3, respectively.

As shown in Fig. 5 (A), first, second and third slits 25a, 25b and 25c for the vapor diffusion flow paths are formed through the upper intermediate plate member 7 so that those slits 25a, 25b and 25c may form the foregoing vapor diffusion flow paths 10 when the upper and lower intermediate plate members 7,8 are joined together. A capillary formation region 26 and those first, second and third slits 25a, 25b and 25c for the vapor diffusion flow paths are formed alternately. As shown in Fig. 5 (B), two or more through-holes 27 are formed through the capillary formation region 26 in a hereinafter-described first pattern so that the through-holes 27 may form said capillary flow paths 11 with the lower intermediate plate member 8.

The first, second and third slits 25a, 25b and 25c for the vapor diffusion flow paths are each formed in a band shape. The first slit 25a for the vapor diffusion flow paths is formed so that it may extend from one corner to the diagonally opposite corner. The second and third slits 25b, 25c for the vapor diffusion flow paths are formed on the sides of the first slit 25a with a predetermined space therebetween.

The capillary formation region 26 includes grid-patterned partition walls 30 so that respective areas demarcated by the partition walls 30 are formed with the through-holes 27. The through-holes 27 are each square-shaped, arranged regularly at equal intervals in the first pattern with four sides thereof being disposed in parallel with the four sides of the contour of the upper intermediate plate member 7, respectively. Incidentally, in the present embodiment, the width of each through-hole 27 is set at about 280 µm, while the width of each partition wall 30 set at about 70µm.

On the other hand, the lower intermediate plate member 8 is formed in the same manner as the upper intermediate plate member 7, except that through-holes 32 are formed through a capillary formation region 31 in a hereinafter-described second pattern. Namely, first, second and third slits 33a, 33b and 33c for the vapor diffusion flow paths 10 are formed through the lower intermediate plate member 8 so that those slits 33a, 33b and 33c may form the foregoing vapor diffusion flow paths 10 when the upper and lower intermediate plate members 7,8 are joined together. A capillary formation region 31 and those first, second and third slits 33a, 33b and 33c for the vapor diffusion flow paths are formed alternately, and two or more through-holes 32 are formed through the capillary formation region 31 in the second pattern so that the through-holes 32 may form said capillary flow paths 11 together with the upper intermediate plate member 7.

The first, second and third slits 33a, 33b and 33c for the vapor diffusion flow paths are formed in the same shape and position as the foregoing first, second and third slits 25a, 25b and 25c of the upper intermediate plate member 7, respectively, such that they may be superimposed on the first, second and third slits 25a, 25b and 25c of the upper intermediate plate member 7 without displacement, respectively, as shown in Fig. 3(A) and (B).

Accordingly, the vapor diffusion flow paths 10 are formed in a region where the first, second and third slits 25a, 25b and 25c for the vapor diffusion flow paths of the upper intermediate plate member 7 are superimposed on the first, second and third slits 33a, 33b and 33c for the vapor diffusion flow paths of the lower intermediate plate member 8 such that the vapor diffusion flow paths 10 may define a wide region where the grid-patterned upper member concave portion 21 of the upper member 2 is in fluid communication with the grid-patterned lower member concave portion 17 of the lower member 2.

As shown in Fig. 5 (B), these vapor diffusion flow paths 10 are formed in the same band shape as the first, second and third slits 33a, 33b and 33c for the vapor diffusion flow paths, and arranged in parallel with a direction from one corner to the diagonally opposite corner.

On the other hand, the grid-patterned partition walls 35 are formed in the capillary formation region 31, while respective areas demarcated by those partition walls 35 are formed with through-holes 32 as shown in Fig. 5 (A). The through-holes 32 are each square-shaped, arranged regularly at equal intervals in the second pattern, with four sides thereof being disposed in parallel with the four sides of the contour or peripheral portion 24 of the lower intermediate plate member 8, respectively, like in the first pattern, except that the through-holes 32 are each displaced a predetermined distance from the through-holes 27 of the upper intermediate plate member 7.

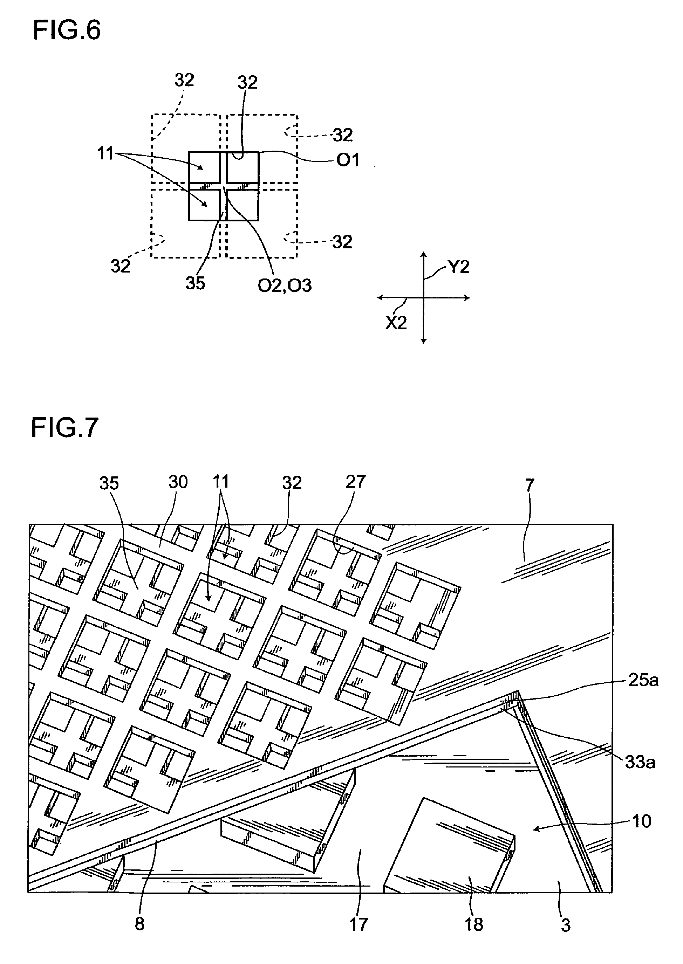

Fig. 6 is a schematic diagram showing how the through-holes 27 of the upper intermediate plate member 7 and the through-holes 32 of the lower intermediate plate member 8 are arranged.

According to the present embodiment, as in the second pattern, the center O1 of each through-hole 32 of the lower intermediate plate member 8 is displaced by a half the length of one side thereof toward a first side of the through-hole 27 of the upper intermediate plate member 7 (i.e., X2 direction), and also by a half the length of one side thereof toward a second side thereof orthogonal to the X2 direction of the through-hole 27 of the upper intermediate plate member 7 (i.e., Y2 direction).

In other words, the lower intermediate plate member 8 is disposed such that the intersection 02 of the partition walls 35 corresponding to the center of the four adjacent through-holes 32 of the lower intermediate plate member 8 is aligned with the center 03 of the through-hole 27 of the upper intermediate plate member 7, so that the four through-holes 32 of the lower intermediate plate member 8 are overlapped with a region defined by the single through-hole 27 in the upper intermediate plate member 7, thereby enabling the four capillary flow paths 11 to be formed.

Fig. 7 is a schematic diagram showing a detailed structure in which the upper and lower intermediate plate members 7, 8 and the lower member 3 are superimposed.

As shown in Fig. 7, it is possible to form each of the capillary flow paths 11 so as to have a cross-sectional area about 1/4 of that of the through-hole 27 in the upper intermediate plate member 7 and the lower intermediate plate member 8, per each through-hole 27 of the upper intermediate plate member 7. Thus, it is possible to form more capillary flow paths 11 in the upper and lower intermediate plate members 7 and 8, each capillary flow path defining a much smaller sectional area and a larger surface area, divided more finely than the through-hole 27 of the upper intermediate plate member 7.

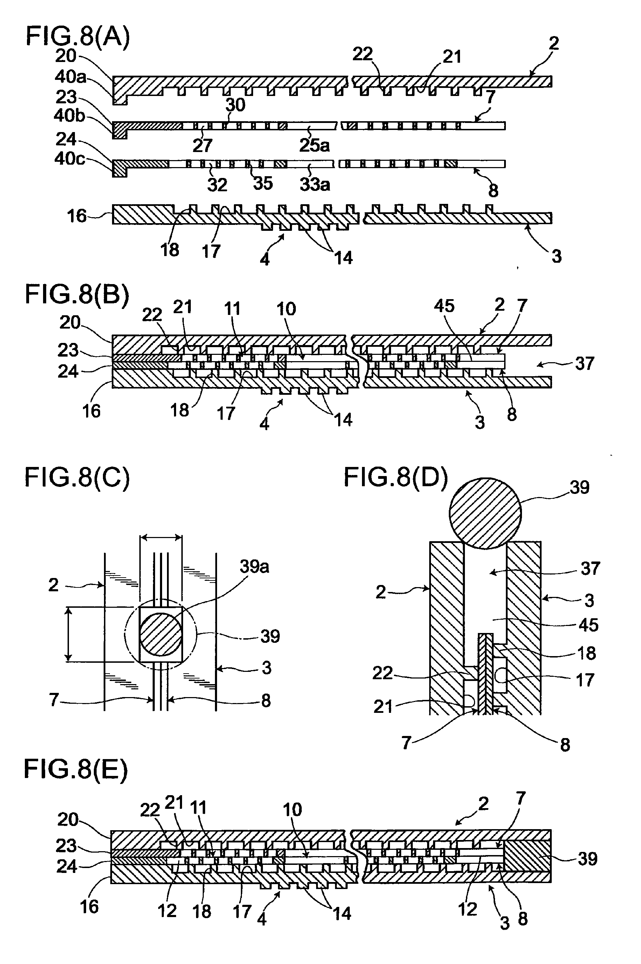

Next is a description of the manufacturing method of the heat pipe 1 of the invention. Figs. 8 (A) to (C) illustrate one example of the manufacturing method of the heat pipe 1. As shown in Fig. 8 (A), the lower member 3, the lower intermediate plate member 8, the upper intermediate plate member 7 and the upper member 2 are prepared first, and then they are superimposed sequentially from the bottom side.

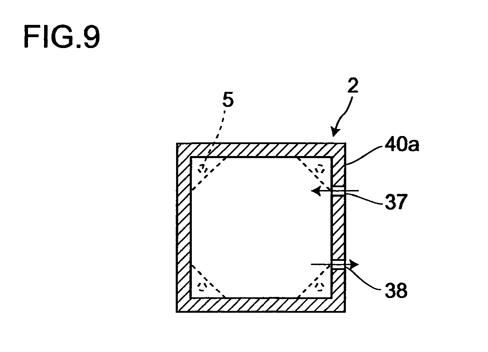

Fig. 9 is a plane cross-sectional view showing the structure of the refrigerant charging hole 37 and the air outlet port 38 in the upper member 2.

As shown in Fig. 9, the refrigerant charging hole 37 and the air outlet port 38 are formed in a part of the peripheral portion 20 of the lower inside surface 2b in the upper member 2. Moreover, the frame-shaped joining projection 40a protruding from the lower inside surface 2b is formed in the peripheral portion 20 except where the refrigerant charging hole 37 and the air outlet port 38a are formed. Thus, the upper member 2 is capable of being directly joined to the upper intermediate plate member 7 via the joining projection 40a.

Moreover, a frame-shaped joining projection 40b projected from the undersurface is formed in the upper intermediate plate member 7 along a peripheral portion 23 so that the lower intermediate plate member 8 may be directly joined thereto through the joining projection 40b. Furthermore, a frame-shaped joining projection 40c projected from the undersurface is formed in the lower intermediate plate member 8 along a peripheral portion 24 so that the lower member 3 may be directly joined thereto through a joining projection 40c. In the present embodiment, the joining protrusions 40a, 40b and 40c are each set to have an about 35 µm height, and an about 50µm width.

Moreover, the refrigerant charging hole 37 and the air outlet port 38 are formed in the lower member 3 as well, like in the upper member 2. The lower member 3, the lower intermediate plate member 8, the upper intermediate plate member 7 and the upper member 2 are positioned based on the positioning holes 5, so that they may be superimposed with the peripheral portions 16, 20, 23 and 24 thereof being aligned with one another.

Thus, the first, second and third slits 25a, 25b and 25c for vapor diffusion flow path of the upper intermediate plate member 7 and the first, second and third slits 33a, 33b and 33c for vapor diffusion flow path of the lower intermediate plate member 8 are superimposed with each other, respectively, between the upper member 2 and the lower member 3, so that a plurality of the vapor diffusion flow paths 10 can be formed to extend towards the peripheral portions 16 and 20 in parallel with a direction from one corner to the diagonally opposite corner (see Fig. 3 (A)).

At the same time, the capillary formation regions 26 of the upper intermediate plate member 7 and the capillary formation regions 31 of the lower intermediate plate member 8 are superimposed with each other between the upper member 2 and the lower member 3, so that a plurality of capillary flow paths 11 can be formed in portions except the positions where the vapor diffusion flow paths 10 are formed.

Then, with the lower member 3, the lower intermediate plate member 8, the upper intermediate plate member 7 and the upper member 2 being superimposed in the optimal locations, those members 3,8, 7 and 2 are heated at a temperature below the melting point and pressed (i.e., hot pressed at e.g., 300 degrees C and at 100kg/cm^{2,}) to thereby be joined directly.

Thus, the lower member 3, the lower intermediate plate member 8, the upper intermediate plate member 7 and the upper member 2 are integrated into a single piece due to the peripheral portions 16, 20, 23, and 24 thereof being directly joined to each other by the joining projections 40a, 40b, and 40c, as shown in Fig. 8 (B). As a result, the interior space 45 of the heat pipe 1 is allowed to communicate with the exterior thereof only through the refrigerant charging hole 37 and the air outlet port 38.

Subsequently, the heat pipe 1 is placed on an installation stand (not shown) so that the refrigerant charging hole 37 and the air outlet port 38 may be positioned on the upper side, and then, a predetermined amount of the liquid refrigerant is charged into the interior space 45 of the heat pipe 1 from the refrigerant charging hole 37 at atmospheric pressure. At that moment, the air inside the interior space 45 of the heat pipe 1 is discharged from the air outlet port 38. As for the amount of the refrigerant to be charged, it is preferable that it may be substantially equal to a total volume of the capillary flow paths when the refrigerant is water.

Thereafter, after charging the refrigerant into the interior space 45 of the heat pipe 1, a sealing member 39 of a spherical shape is placed on the refrigerant charging hole 37 and the air outlet port 38, respectively, as shown in Figs.8 (C) and (D). Under that condition, vacuum deaeration is preformed (at 0.5 KPa, for example) for about 10 minutes at low temperature (for example, zero degree C to normal temperature (e.g., 25 degrees C)) through the clearances between the sealing member 39 and the refrigerant charging hole 37 and the sealing member 39 and the air outlet port 38, respectively, and then pressing is applied from above to the sealing member 39 (at 10-80 kg/cm²) for several minutes, for example, using a press device (not shown), under that low temperature condition, to thereby cause low-temperature pressure-deformation. Thus, the refrigerant charging hole 37 and the air outlet port 38 are temporarily sealed by carrying out such low-temperature vacuum pressurization processing. At this time, the refrigerant charging hole 37 and the air outlet port 38 are closed by the sealing members 39.

In the meantime, a temperature at which vacuum deaeration is to be performed is preferably as low as about 20 degrees C, and a pressure at which the sealing member 39 is to be subjected to low- temperature pressurization deformation is preferably about 60 kg/cm².

Here, the refrigerant charging hole 37 and the air outlet port 38 are each formed in a rectangular shape having a long side of 600 µm and a short side of 400 µm such that a clearance may be formed between a mounting section 39a of the sealing member 39 having a circular cross-section and a neighborhood of the corners. Thus, it is possible to deaerate the interior space 45 through the clearance when sealing with the sealing members 39 in the refrigerant charging hole 37 and the air outlet port 38, as shown in Fig. 8(C).

Next, after the low-temperature vacuum heating treatment, the sealing member 39 is further pressed from above (at 30-150 kg/ cm²) for about 10 minutes, for example, under a high temperature condition (from normal temperature (e.g., about 25 degrees C) to 180 degrees C), with a degree of vacuum being set to 0.5KPa, for example. As a result, the sealing member 39 is turned into plastic flow, and subjected to a high-temperature pressurization deformation so that the refrigerant charging hole 37 and the air outlet port 38 are still more firmly closed by the sealing members 39 serving as sealing plugs. Accordingly, it is possible to manufacture the heat pipe 1 so that the interior space 45 thereof may serve as the sealed space 12 in which the refrigerant is enclosed.

In the meantime, a temperature at which the further pressing is to be performed is preferably about 120 degrees C, and a pressure at which the sealing member 39 is to be subjected to high- temperature pressurization deformation is preferably about 100 kg/ cm².

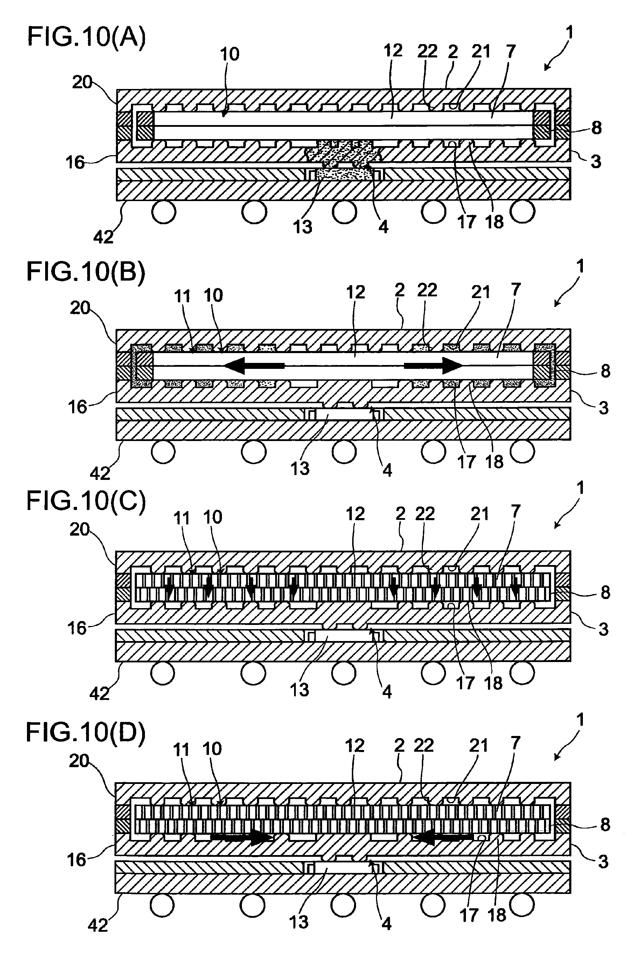

Fig. 10 (A) is a schematic diagram showing a side sectional structure of the vicinity of the vapor diffusion flow path 10 in the heat pipe 1, illustrating how the heat is transferred from the device to be cooled 13. Fig. 10 (B) is also a schematic diagram showing a side sectional structure of the vicinity of the vapor diffusion flow path 10 in the heat pipe 1, illustrating how the vapor is diffused.

Fig. 10 (C) is a schematic diagram showing a side sectional structure of the vicinity of the capillary flow paths 11 in the heat pipe 1, illustrating how the refrigerant is guided into the grid-patterned lower member concave portion 17 through the capillary flow paths 11. Fig. 10 (D) is also a schematic diagram showing a side sectional structure of the vicinity of the capillary flow paths 11 in the heat pipe 1, illustrating how the refrigerant is guided to the center through the grid-patterned lower member concave portion 17.

According to the heat pipe 1 of the foregoing structure, the vapor diffusion flow paths 10 extending up to the peripheral portions 16 and 20 in parallel with the direction from one corner to the diagonally opposite corner are provided in the sealed space 12, whereby the heat from the device to be cooled 13 mounted on a printed wiring board 42, for example, is absorbed by the refrigerant and thus it is heated and then evaporated so that the vapor is guided into the vapor diffusion flow paths 10 that are spaces free from resistance, as shown in Fig. 10 (A). Then, the vapor is allowed to diffuse toward the peripheral-portions 16 and 20 through the vapor diffusion flow paths 10 so that it is subjected to the heat loss and thus condensed in the peripheral portions 16 and 20 of the heat pipe 1, as shown in Fig. 10 (B).

Moreover, according to the forgoing heat pipe 1, the two or more minute capillary flow paths 11 are formed in portions except the positions where the vapor diffusion flow paths 10 are formed. Accordingly, as shown in Fig. 10 (C), the refrigerant liquefied due to heat loss and condensation in the peripheral portions 16 and 20, the upper member 2 and the capillary flow paths 11 is guided into the grid-patterned lower member concave portion 17 through the capillary flow paths 11 due to the capillary phenomenon, and then, as shown in Fig. 10 (D), it is allowed to return to the center side (namely, toward the device mounting section 4) again through the grid-patterned lower member concave portion 17. Thus way, according to the heat pipe 1 of the invention, the circulating phenomenon of the refrigerant shown in Fig. 10 (A) to (D) is repeated successively, whereby heat is drawn from the device to be cooled 13 by the latent heat at the time of the evaporation of the refrigerant, and thus the heat is dissipated, enabling the effective cooling of the device to be cooled 13.

Also, according to the foregoing heat pipe 1, the through-hole 27 formed through the upper intermediate plate member 7 is allowed to be only partially overlapped with the through-hole 32 formed through the lower intermediate plate member 8 with the former being displaced from the latter a predetermined distance, by simply superimposing the upper intermediate plate member 7 on the lower intermediate plate member 8 so that the peripheral portions thereof may be aligned with each other, based on the positioning holes 5.

According to the foregoing heat pipe 1, therefore, the through-hole 27 of the upper intermediate plate member 7 is divided into multiple sections by the partition walls 35 of the lower intermediate plate member 8, thus enabling the simple formation of the even more minute capillary flow paths 11 that go beyond the limit of miniaturization techniques for miniaturizing the through-holes 27, 32 of the upper and lower intermediate plate members 7, 8.

Since the foregoing heat pipe 1 enables the capillary action resulting from the capillary phenomenon to be even more strengthened, corresponding to the miniaturization of the capillary flow path 11, it is possible to more reliably lead the refrigerant to the grid-patterned lower member concave portion 17 by such strengthened capillary action, thereby even more ensuring the successive repetition of the circulating phenomenon of the refrigerant. Further, the through-hole 27 of the upper intermediate plate member 7 and the through-hole 32 of the lower intermediate plate member 8 form the capillary flow paths 11 in the form of the fine sections divided in the heat pipe 1, whereby it is possible to enlarge the total surface area of the capillary flow paths 11, and thus the amount of the vapor deposited on the capillary flow paths 11 increases, thereby facilitating the heat loss of the vapor.

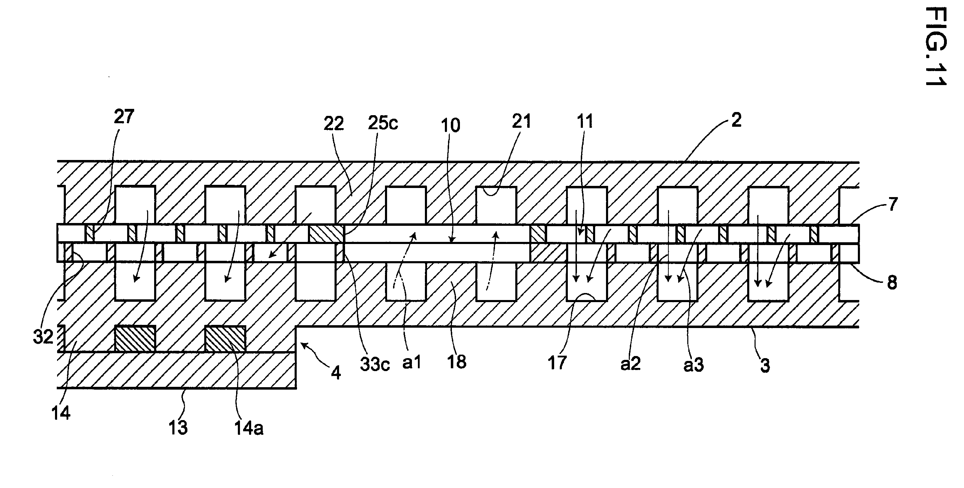

Fig. 11 is a side sectional view showing a detailed structure of a portion in the heat pipe 1 where the vapor diffusion flow path 10 and the capillary flow path 11 are formed alternately. As shown in Fig. 11, the through-hole 27 of the upper intermediate plate member 7 is displaced from the through-hole 32 of the lower intermediate plate member 8 toward the peripheral portions 16 and 20 (i.e., the direction to move away from the device mounting section 4), whereby not only the capillary flow path 11 that extends vertically but also the capillary flow path 11 that extends obliquely toward the peripheral portions 16 and 20 when extending to the lower member 3 from the upper member 2 can be formed.

Consequently, in the vicinity of the device to be cooled 13 that contains a larger amount of heat and thus generates comparatively much vapor, the vapor is not only led to the vapor diffusion flow paths 10 (i.e., the direction indicated by an arrow a1 in the drawing), but also is allowed to go obliquely upward from the center side toward the peripheral portions 16 and 20 through each capillary flow path 11 as well, whereby it is spread toward the peripheral side when going up through the capillary flow paths 11, thus promoting the heat spreading toward the peripheral portions 16 and 20, the upper member 2 and the capillary flow paths 11, thereby realizing effective heat dissipation.

Moreover, according to the foregoing heat pipe 1, the refrigerant liquefied due to the heat dissipation and condensation in the peripheral portions 16 and 20, the upper member 2 and the capillary flow paths 11 is subjected to the capillary action so that it is allowed to go down vertically toward the grid-patterned lower member concave portion 17 (i.e., the direction indicated by an arrow a2 in the drawing) through the capillary flow paths 11, while the refrigerant can be then returned to the center side efficiently through the grid-patterned lower member concave portion 17.

Furthermore, according to the foregoing heat pipe 1, the refrigerant liquefied due to the heat dissipation and condensation in the peripheral portions 16 and 20, the upper member 2 and the capillary flow paths 11 is subjected to the capillary action so that it is also allowed to go down directly towards the grid-patterned lower member concave portion 17 on the center side through the capillary flow paths 11 extending obliquely therefrom toward the center (i.e., the direction indicated by an arrow a3 in the drawing), thus enabling the refrigerant to be also returned to the center side efficiently.

In the meantime, whilst the refrigerant liquefied due to the heat dissipation and condensation in the peripheral portions 16 and 20, the upper member 2 and the capillary flow paths 11 is led to the grid-patterned lower member concave portion 17 primarily via the capillary flow paths 11, it is also led to the grid-patterned lower member concave portion 17 secondarily via the vapor diffusion flow paths 10. According to the foregoing heat pipe 1, therefore, heat dissipation of the device to be cooled 13 can be even more effectively performed due to the above-described circulating phenomenon of the refrigerant being repeated successively.

Additionally, according to the foregoing heat pipe 1, the vapor diffusion flow paths 10 are not directly communicated with and the capillary flow paths 11, but only indirectly communicated therewith through the grid-patterned lower member concave portion 17 and the grid-pattemed upper member concave portion 21. As a result, the diffusion of the vapor in the vapor diffusion flow paths 10 is not hindered by the capillary action in the capillary flow paths 11, thus ensuring the vaporized refrigerant to be led to the peripheral portions 16 and 20. Further, the capillary action in the capillary flow paths 11 is not weakened by the diffusion of the vapor in the vapor diffusion flow paths 10, thus ensuring the liquefied refrigerant to be led to the grid-patterned lower member concave portion 17 through the capillary flow paths 11.

In addition to the foregoing, according to the foregoing heat pipe 1, the adhesive resin 14a is provided in a clearance where no projections 14 are formed on the device mounting section 4, while the projections are allowed to come in direct contact with the device to be cooled 13, whereby it is possible to transfer the heat from the device to be cooled 13 promptly to the heat pipe 1 via the projection 14, not via the adhesion resin 14a, with the device to be cooled 13 being fixedly mounted to a desired position on the device mounting section 4.

In the meantime, when two surfaces each having a wide area are brought into close contact with each other, an air is likely to be confined in an inside space formed between the two surfaces, even though such inside space is a minute one. Therefore, if the device to be cooled 13 is mounted onto the planar lower outside surface 3a of the heat pipe 1, there is a likelihood that an air layer having an extremely large heat resistance may be formed between the lower outside surface 3a and the device to be cooled 13. In that case, there is a problem that a thermal efficiency will fall.

According to the present embodiment, each projection 14 is of a square pillar shape, having a distal end surface of from 50 to 300 µm square, and arranged regularly at equal intervals of 500-1,000 µm pitch in the device mounting section 4 of 15,000 µm square, thereby preventing the device to be cooled 13 from coming in close contact with the lower member 3 with mutually wide areas. Accordingly, the air layer in which thermal resistance is very large is made less likely to be formed between the two opposite surfaces, ensuring the heat of the device to be cooled 13 to be continuously and successively transferred to the lower member 3.

In the meantime, the thermal conductivity of the copper that forms the projections 14 is 390 W/m-K, and that of the adhesive resin 14a is in a range of from 4 to 6 W/m-K, and that of the air is close to 0 W/m-K, respectively.

Moreover, according to the foregoing heat pipe 1, the two or more vapor diffusion flow paths 10 are formed in parallel with the direction from one corner to the diagonally opposite corner so that the vapor may diffuse through those vapor diffusion flow paths 10, thus enabling the peripheral portions 16 and 20, the upper member 2, the capillary flow paths 11 and the vicinity of the pair of the corners to contribute to heat dissipation, thereby attaining effective heat dissipation and enhanced heat conduction effect.

Still moreover, according to the foregoing heat pipe 1, the lower member 3, the lower intermediate plate member 8, the upper intermediate plate member 7 and the upper member 2 are directly joined together by the joining protrusions 40a, 40b and 40c, whereby the joining process for integration of the lower member 3, the lower intermediate plate member 8, the upper intermediate plate member 7 and the upper member 2 can be performed without the need for any welding material, bonding material and the like, and thus no impurities derived from the welding or bonding material are allowed to be mixed into the heat pipe 1.

### Second Embodiment

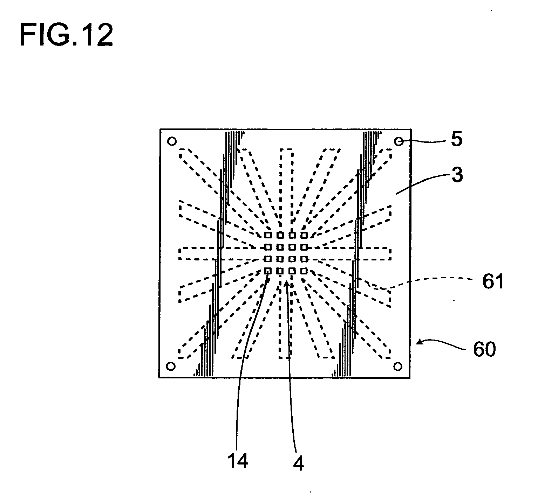

Fig. 12 shows a heat pipe 60 of a second embodiment the present invention, of which the structure does not differ from the first embodiment except that all vapor diffusion flow paths 61 are formed to extend radially from the center of the device mounting section 4.

According to the foregoing heat pipe 60, the effective heat dissipation from the center to the corners is even more facilitated, thus enabling the substantially entire area of the heat pipe 1 including its corners to contribute to the heat dissipation uniformly and effectively. Accordingly, effective circulation of the refrigerant from the center to the corners is facilitated due to the diffusion of vapor by the vapor diffusion flow paths as well as the return of the refrigerant by the capillary flow paths, thus further enhancing the heat conduction effect.

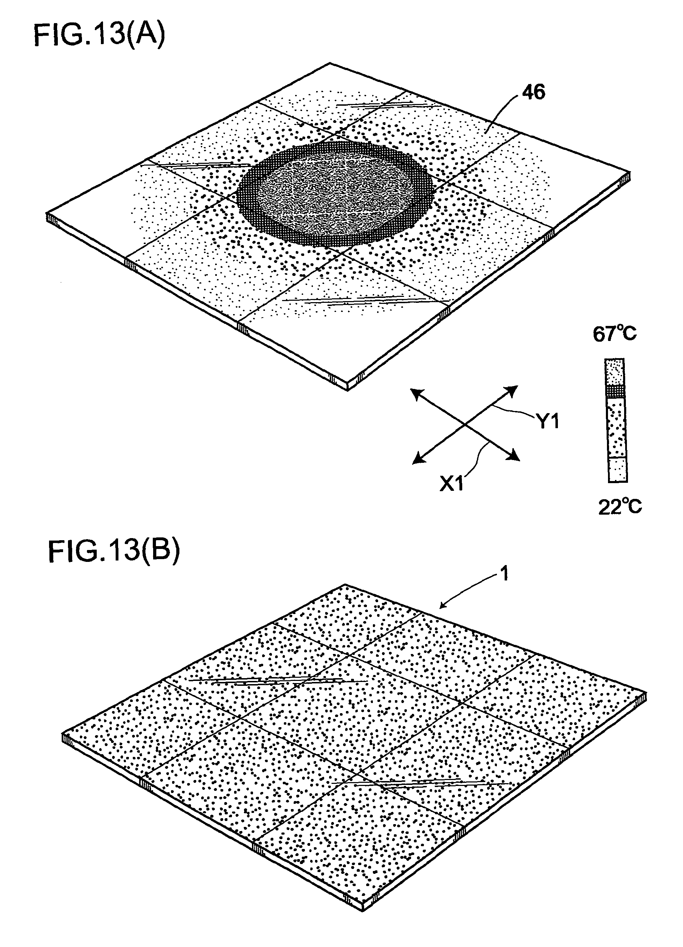

Then, a simulation test was performed on heat spreading property between the heat pipe 60 and a copper heat spreader, and the following simulation result was obtained. Specifically, a 1mm-thick copper plate of 40mm square as shown in Fig. 13 (A), and the heat pipe 60 of the present invention having the same thickness and area as the copper plate 46, as shown in Fig. 13 (B) were used. The simulation test was performed on the respective heat spreading property of the copper plate and the heat pipe 60 each having a 15mm square area (not shown) in the central part of the lower outside surface, each 15mm square area having been heated at 444 kW/m².

As shown in Fig. 13 (A), the central part of the copper plate 46 reached as high as about 67 degrees C, and a ring-shaped surrounding of the central part reached a lower temperature of about 52 degrees C, and then the surrounding of the ring-shaped surrounding reached about 47-27 degrees C. Further, the outermost surrounding thereof reached about 22 degrees C. Thus, difference in temperature between the central part and the outermost surrounding became extremely large in the copper plate 46.

On the other hand, according to the heat pipe 60 as shown in Fig. 13 (B), the resultant temperature was about 47 to 27 degrees C over the entire area thereof. Thus, it was demonstrated that temperature distribution was substantially uniform in the heat pipe 60, and nowhere in the heat pipe 60 reached such a high temperature as 67 degrees C.

In other words, it was demonstrated from the temperature distribution shown in Fig. 13 (A) and (B) that the heat dissipation effect of the heat pipe 60 was extremely superior to that of the copper plate 46. Moreover, when comparing both in terms of surface temperature, the heat-dissipation effect about 20 times as high as that of the copper plate 60 could be obtained by using the heat pipe 60 of the present invention.

Next, another test was performed on heat spreading property between the 1 mm thick copper heat spreader (comparative example 1) and the heat pipe 60 having a thickness of 1.2 mm from the upper surface of the upper member 2 to the lower surface of the lower member 3. In the meantime, both were of 40mm square and heated until the central part for mounting the device to be cooled 13 thereto reached 50, 45, 40 and 35 degrees C, respectively.

This means that the amount of heat given to the more heat conductive heat pipe 60 of the present invention should be greater than the comparative example 1, since both were heated until the central parts thereof reached the same temperature.

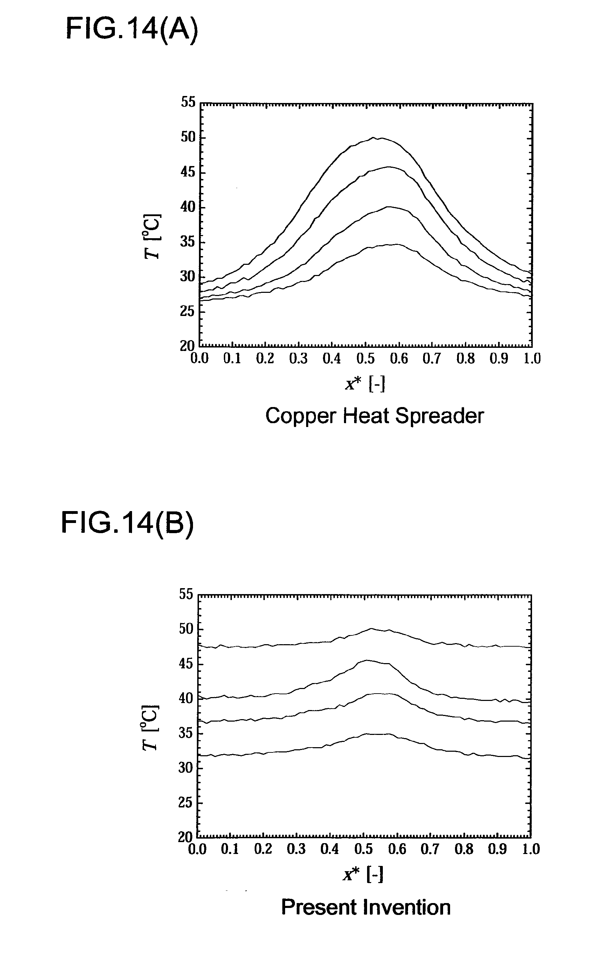

Fig. 14(A) and (B) are each graphical presentation of temperature distributions obtained in the foregoing test, in which Fig. 14 (A) shows those in the comparative example 1, while Fig. 14 (B) shows those in the heat pipe 60 of the present invention. Fig. 14 (A) and (B) each present the temperature distributions in the transverse direction (i.e., X1 direction as one planar direction) of the samples shown in Fig. 13. The axis of abscissas of each graph shown in Fig. 14 (A) and (B) is standardized such that the center thereof may correspond to the position in which the device to be cooled 13 was provided, and the length of each sample in the X1 direction may be 1.0.

In the above case, when the central part of the sample of the comparative example 1 was at 50 degrees C, as shown in Fig. 14 (A), heat was not easily transferred up to the peripheral portions distant from the central part, and thus it could be confirmed that there was a great difference in temperature between the central part and the peripheral portions thereof.

In contrast, according to the heat pipe 60, it could be confirmed that a difference in temperature was small between the central part and its peripheral portion, as shown in Fig. 14 (B), This demonstrates that according to the heat pipe 60, the circulation of the refrigerant inside the heat pipe could make the entire area including the corners thereof to contribute to the heat dissipation, thus indicating extremely high heat spreading effect as compared with the comparative example 1.

Subsequently, the sample of the comparative example 1 and the heat pipe 60 of the present invention were heated to 45 and 40 degrees C, respectively, from the result of which could be confirmed that there was a great difference in temperature between the central part and its peripheral portion in the comparative example 1, while only a small difference in the heat pipe 60.

Further, when the sample of the comparative example 1 was heated to 35 degrees C, it could be confirmed that heat was not easily transferred up to the peripheral portions distant from the central part, and thus there was a great difference in temperature between the central part and the peripheral portions thereof, as shown in Fig. 14(A). According to the heat pipe 60 of the present invention, however, it could be confirmed that a difference in temperature was smaller between the central part and its peripheral portion than the comparative example 1, as shown in Fig. 14 (B), even when the central part thereof was heated to 35 degrees C. That is, according to the heat pipe 60 of the present invention, it was confirmed that heat spreading effect is still extremely high even when the temperature of the central part is slightly higher than normal temperature as well as when it is 50 degrees C or less.

### Third Embodiment

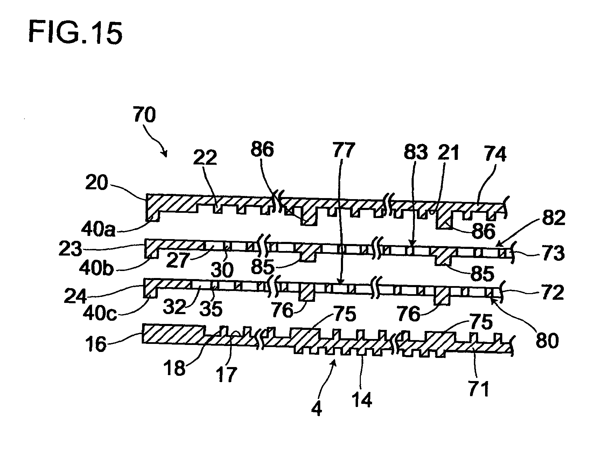

In Fig. 15 showing the side cross-sectional structure of an upper member, an upper intermediate plate member, a lower intermediate plate member, and a lower member, numeral 70 designates a heat pipe according to the third embodiment, comprising the lower member 71, the lower intermediate plate member 72, the upper intermediate plate member 73 and the upper member 74 superimposed in sequence. The heat pipe 70 of the third embodiment differs from that of the second embodiment in that not only the peripheral portions 16, 20, 23 and 24 but also the regions of the device mounting section 4 are subjected to the direct joining by the hot press.

Specifically, a receiving portion 75 is formed in a position opposite to the vicinity of the corners of the device mounting section 4. The receiving portion 75 receives a joining projection 76 (hereafter called an intermediate plate member center projection) slightly projected from the undersurface of the lower intermediate plate member 72 so that the intermediate plate member central projection 76 may be directly joined thereto by hot press.

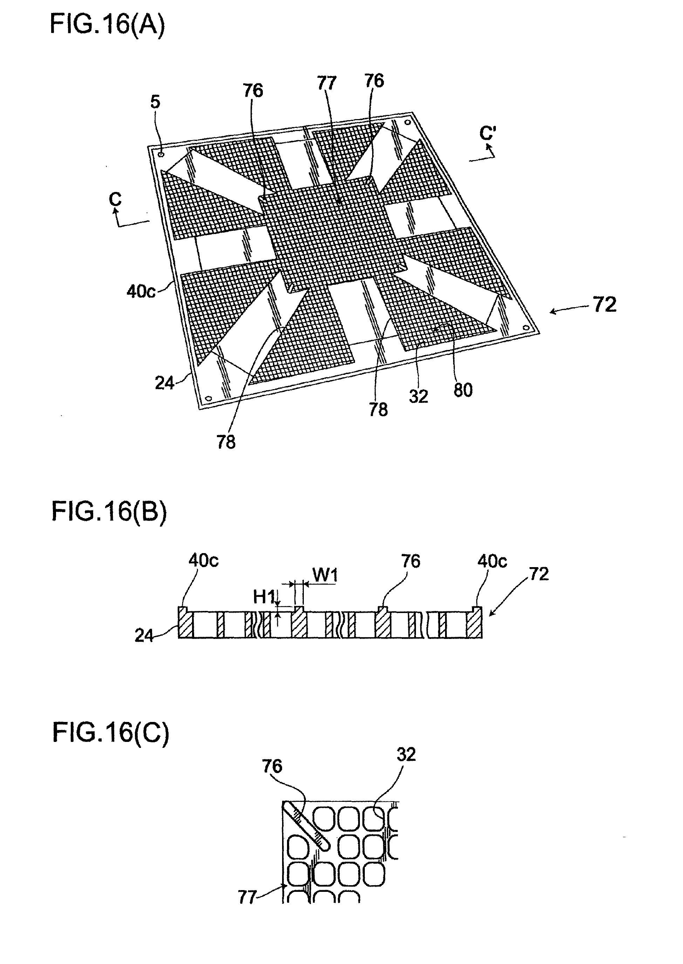

As shown in Fig. 16 (A), a square-shaped central capillary formation region 77 is provided on the lower intermediate plate member 72, corresponding to the region of the device mounting section 4. As shown in Fig. 16 (B) showing a sectional structure taken on a C-C' line of Fig. 16 (A), and also as shown in Fig. 16 (C) showing a plan view of a principal part of the lower intermediate plate member 72, the intermediate plate member central projection 76 is provided at the four corners of the central capillary formation region 77, respectively.

In the present embodiment, the intermediate plate member central projection 76 is formed in a minute square pillar shape having a width W1 of about 50 µm, and a height H1 of about 35 µm, arranged so that it longer side is directed to the center.

According to the present embodiment, eight slits 78 for vapor diffusion flow paths are formed through the lower intermediate plate member 72 so that they extend radially from the central capillary formation region 80. Between the slits 78 for vapor diffusion flow paths are provided the capillary formation region 80 with the through-holes 79 formed therethrough in the second pattern. In addition, the through-holes 32 are formed through the central capillary formation region 77 in the second pattern as well.

Although the upper intermediate plate member 73 to be integrated with the lower intermediate plate member 72 is formed in the same manner as the lower intermediate plate member 72, it differs in that the through-holes 27 are formed in the capillary formation regions 82 and the central capillary formation region 83 in the first pattern. In addition to the foregoing, the upper intermediate plate member 73 is provided with an intermediate plate member central projection 85 slightly protruding from a certain position on the lower surface thereof, opposing the receiving portion 75 so that it may be directly joined to the lower intermediate plate member 72 through the intermediate plate member central projection 85 by hot press. Thus, the upper intermediate plate member 73 and the lower intermediate plate member 72 can be integrated with each other.

The upper member 74 is provided with a joining projection 86 (hereinafter called an upper central projection 86) slightly protruding from a certain position on the lower inside surface thereof, opposing the receiving portion 75 of the lower member 71 so that it may be directly joined to the upper intermediate plate member 73 through the upper central projection 86 by hot press. Thus, the upper member 74 and the upper intermediate plate member 73 can be integrated with each other.

Thus way, the heat pipe 70 prior to enclosing a refrigerant can be manufactured, and then a refrigerant is enclosed within the interior space, like in the foregoing second embodiment.

According to the heat pipe 70 of the foregoing structure, not only the same effect as the second embodiment can be obtained, but the mechanical strength of the heat pipe itself can be improved because the intermediate plate member central projections 76 and 85 along with the upper central projection 86 are formed in the positions opposite to the device mounting section 4, and thus the direct joining is achieved not only in the peripheral portions 16, 20, 23, and 24 but in the positions opposite to the device mounting section 4, thus providing a support structure in the central part opposite to the device mounting section 4.

In the meantime, according to conventional heat pipes (not shown), there has been a problem that the heat pipe tends to be expanded toward the outside nearly in the center thereof due to the thermal expansion of the refrigerant caused by the temperature rise of the refrigerant by the heat generated from the device to be cooled (so-called "Popcorn phenomenon"), which sometimes destructs the joint between the upper member and the lower member, leading to the failure of the head pipe.

According to the heat pipe 70 of the present invention, however, such Popcorn phenomenon can be prevented due to the mechanical strength improved by the support structure provided in the central part, opposite to the device mounting section 4. Accordingly, destruction of the heat pipe 70 itself by the Popcorn phenomenon can be prevented, to thereby enhance the reliability of the heat pipe, ensuring the heat pipe a longer service life.

According to the foregoing structure, the lower member 71, the lower intermediate plate member 72, the upper intermediate plate member 73 and the upper member 74 are directly joined together by hot press not only in the peripheral portions 16, 20, 23, and 24 but also the portions where the intermediate plate member central projections 76 and 85 and the upper central projection 86 formed in the portions corresponding to the peripheral portion of the device mounting section 4, whereby it is possible to prevent the thermal expansion caused by the heat generated from the device to be cooled 13 and the destruction of the heat pipe 70 itself that might be caused by the expansion, thus improving the reliability of the heat pipe 70, elongating the service life thereof.

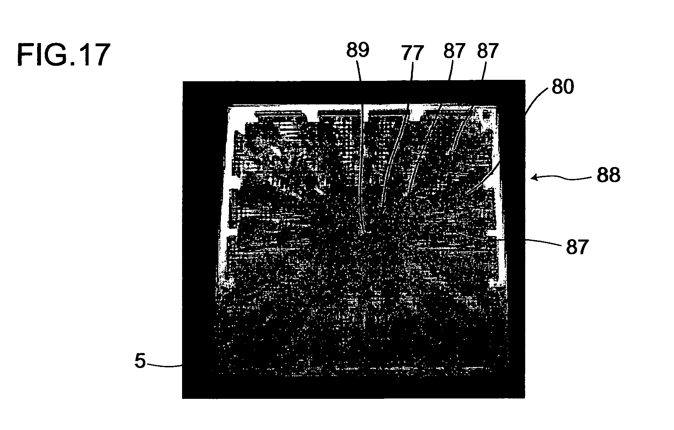

In the meantime, whilst the intermediate plate member central projection 76 is formed in the four corners of the central capillary formation region 77, corresponding to the peripheral portion of the device mounting section 4 in the foregoing embodiment, the present invention should not be limited thereto. As shown in Fig. 17 illustrating an outline structure of an intermediate plate member 88 of another embodiment, intermediate plate member central projections 87 and 89 may be provided in portions corresponding to the peripheral portion of the device mounting section 4 and its neighborhood, in addition to the four corners in the central capillary formation region 77.

More specifically, the intermediate plate member central projection may be provided not only in the four corners of the central capillary formation region 77 but also in other portions in the intermediate plate member 88, such as the intermediate plate member central projection 89 provided in the center of the central capillary formation region 77 and the intermediate plate member center-vicinity projection 87 provided in any of the capillary formation regions 80. It should be noted that as long as the destruction by the Popcorn phenomenon can be prevented, the intermediate plate member central projection may be provided in any arbitrary position, corresponding to the peripheral portion of the device mounting section 4 and the neighborhood thereof.

### Fourth Embodiment

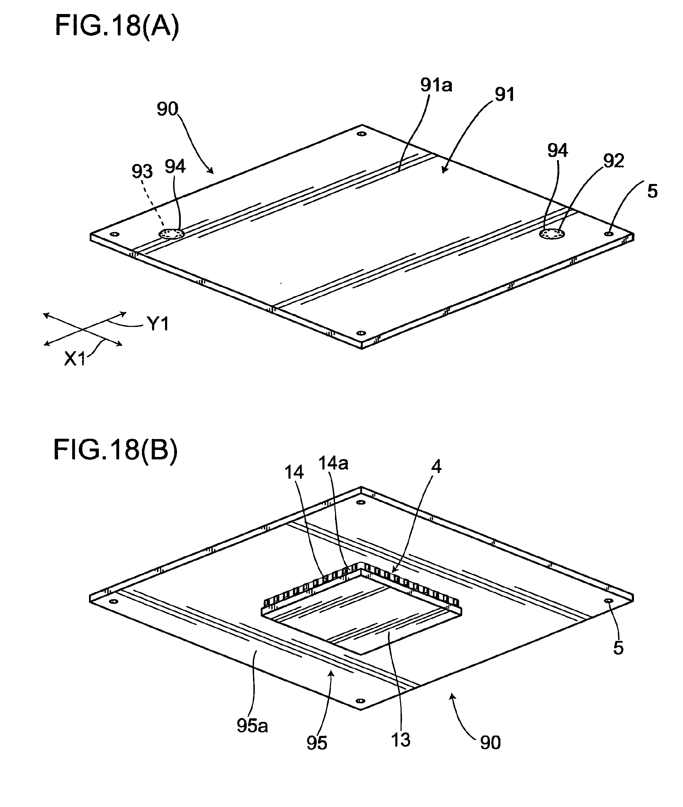

In Fig. 18 (A) showing an outline structure of the upper outside surface of a heat pipe, numeral 90 designates a heat pipe of the present invention, featured by a specific method for enclosing a refrigerant. The heat pipe 90 comprises a refrigerant charging hole 92 and an air outlet port 93 formed through an upper outside surface 91 a of an upper member 91, said refrigerant charging hole 92 and air outlet port 93 being sealed by a sealing member 94 as a sealing plug made from ductile metal material, such as a solder, said sealing member 94 being brought into plastic flow.

According to the present embodiment, the refrigerant charging hole 92 is provided in the vicinity of one of diagonally opposite two corners, while the air outlet port 93 is provided in the vicinity of the other of the diagonally opposite two corners. The heat pipe 90 is so structured that the device to be cooled 13 mounted on the lower outside surface 95a of the lower member 95, as illustrated in Fig. 18 (B) showing an outline structure of the lower outside surface of the heat pipe 90, can be cooled efficiently by the refrigerant enclosed in the sealed space through the refrigerant charging hole 92.

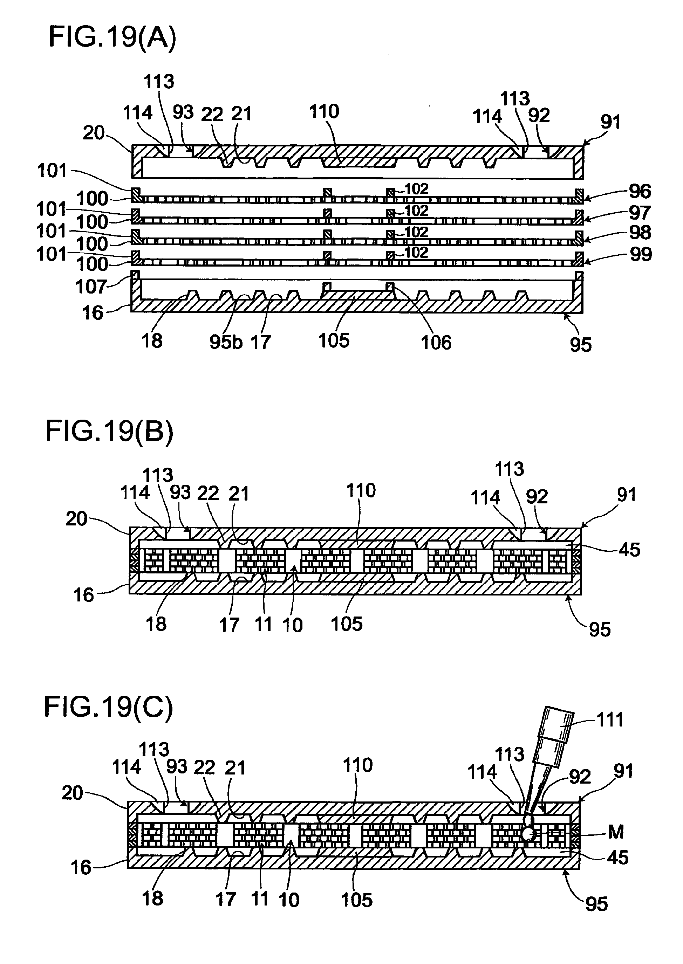

As shown in Fig. 19 (A) showing manufacturing steps of the heat pipe 90 in sequence, this heat pipe 90 comprises the upper member 91 and the lower member 95, and the first, second, third and fourth intermediate plate members 96, 97, 98 and 99 provided between the upper and the lower members 91 and 95. These upper member 91, the first intermediate plate member 96, the second intermediate plate member 97, the third intermediate plate member 98 and the fourth intermediate plate member 99, and the lower member 95 are superimposed, and then joined directly to each other by hot press so as to be formed into a single piece.

Specifically, the first intermediate plate member 96, the second intermediate plate member 97, the third intermediate plate member 98, and the fourth intermediate plate member 99 include a joining protrusion 101 on the upper surface of the peripheral portion 100, respectively, and two or more intermediate plate member central projections 102 slightly protruding from the upper surface in a location corresponding to the device mounting section 4, which are joined directly to each other by hot press so as to be formed into a single piece.

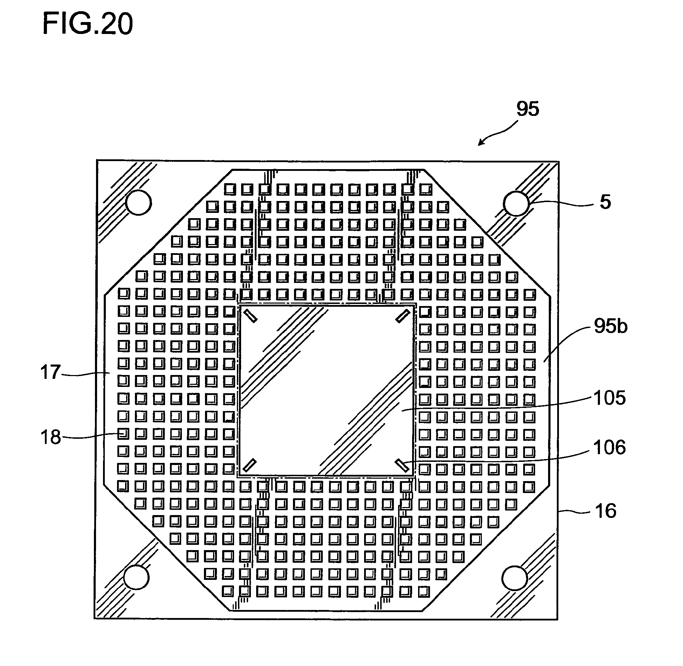

The grid-patterned lower member concave portion 17 is formed in the lower member 95 as shown in Fig. 20 showing the overall structure of the upper inside surface thereof, while a lower abutting portion 105 of a square shape is formed in a region of the upper inside surface 95b, corresponding to the device mounting section 4, and a lower central projection 106 of a rectangular shape is provided in respective corners of the lower abutting portion 105, each of said lower central projection 106 slightly protruding therefrom.

The lower central projection 106 is able to be joined directly to the fourth intermediate plate member 99, together with the joining protrusion 107 provided along with the peripheral portion 16.

When the upper member 91, the first intermediate plate member 96, the second intermediate plate member 97, the third intermediate plate member 98, the fourth intermediate plate member 99 and the lower member 95 are integrated into a single piece, the lower abutting portion 105 is integrated with the fourth intermediate plate member 99, thereby forming a support structure in the central part, together with the intermediate plate member central projection 102 and an upper abutting portion 110.

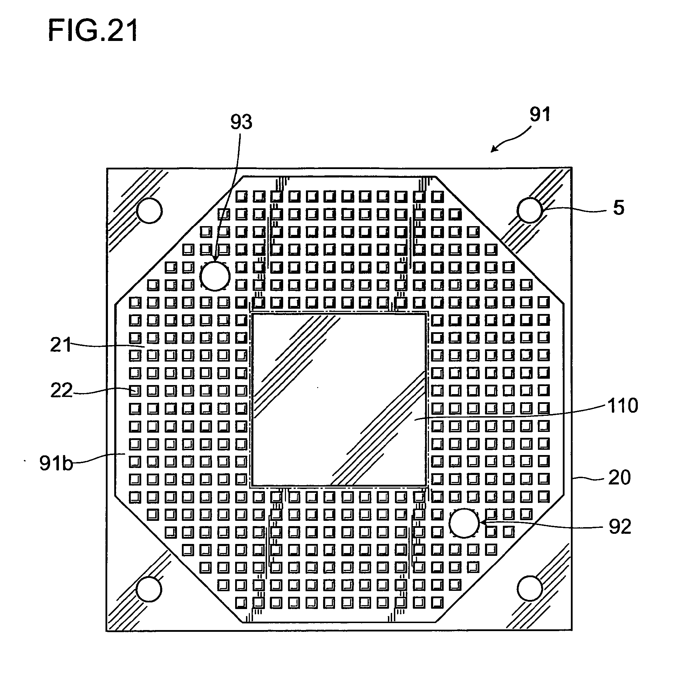

As shown in Fig. 21 showing the overall structure of the lower inside surface of the upper member 91, the grid-patterned upper member concave portion 21 is formed in the upper member 91, while the upper abutting portion 110 is formed in a region of the lower inside surface 91b, corresponding to the device mounting section 4, When the upper member 91, the first intermediate plate member 96, the second intermediate plate member 97, the third intermediate plate member 98, the fourth intermediate plate member 99 and the lower member 95 are integrated into a single piece, the upper abutting portion 110 is integrated with the fourth intermediate plate member 99, thereby forming a support structure in the central part.

In this way, the lower member 95, the fourth intermediate plate member 99, the third intermediate plate member 98, the second intermediate plate member 97, the first intermediate plate member 96, and the upper member 91 are stacked from a bottom side in sequence, and then positioned properly based on the positioning holes 5. Thereafter, hot press is applied thereto so that the members are joined directly to each other so as to be formed into one piece, as shown in Fig. 19 (B).

Then, as shown in Fig. 19 (C), a predetermined amount of the refrigerant M (water, for example) is charged from the refrigerant charging hole 92 into an interior space 111 inside the heat pipe 90 at an atmospheric pressure, using a refrigerant dispenser 111. At that moment, the air outlet port 93 serves as an outlet of the air when charging the refrigerant, thus facilitating the charging of the refrigerant M into the interior space 111. As for the amount of the refrigerant M to be charged, it may be desirably substantially equal to a total volume of the through-hole if the refrigerant is water.

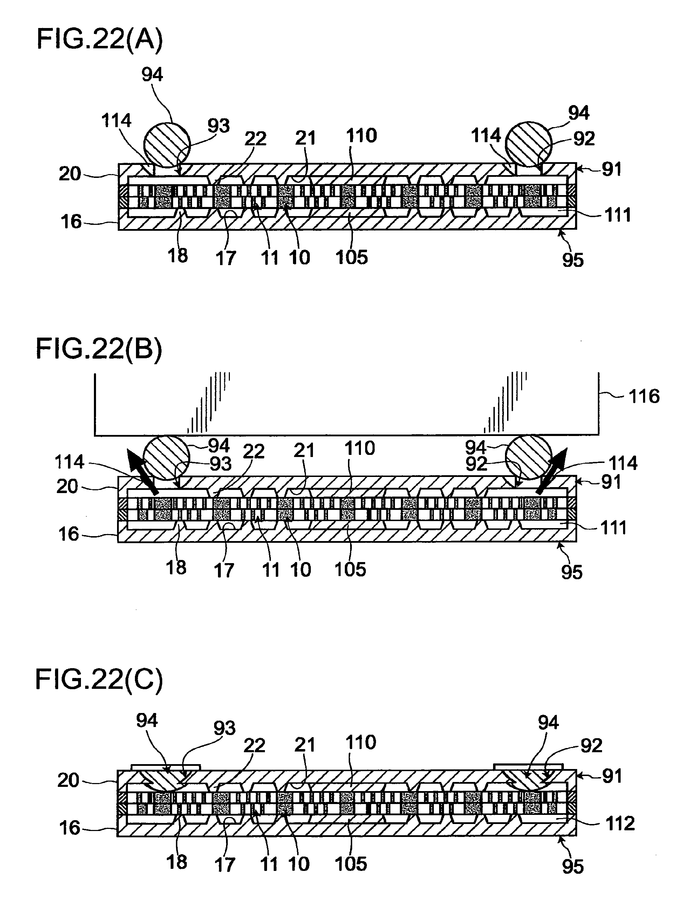

Next, a predetermined number of the sealing members 94 of a spherical shape, for example, is prepared beforehand, and then the sealing member 94 is placed on the refrigerant charging hole 92 and the air outlet port 93, respectively, as shown in Fig. 22
(A) illustrating another example of the manufacturing steps of the heat pipe 90 in sequence.

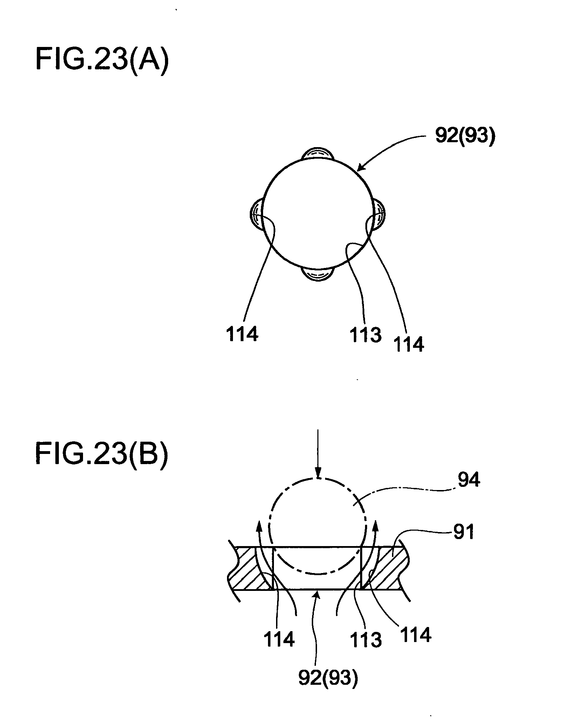

The refrigerant charging hole 92 serving as a hole for charging the refrigerant and the air outlet port 93 are of the same shape. As shown in Fig. 23 (A) showing the planar structure of the refrigerant charging hole 92, and Fig. 23 (B) showing the side sectional structure of the refrigerant charging hole 92 (B), it comprises a cylindrical opening 113 whose central part is most widely opened and two or more degassing grooves 114 provided on the inside peripheral surface of the cylindrical opening 113.

In the present embodiment, the degassing groove 114 is formed in a semi-cylindrical shape having a smaller diameter than that of the opening 113, and arranged in four positions at equal intervals on the inner circumference of the opening 113.

Under that condition, vacuum deaeration (at 0.5KPa, for example) is performed for about e.g., 10 minutes by pressure reduction through the degassing grooves 114 under a low temperature condition (from 0 degree C to normal temperature (for example, about 25 degrees C)), and then under that low temperature state, the sealing member 94 is pressed (e.g., at 10-80 kg/ cm²) from above by a press for several minutes so that it is subjected to low temperature pressure deformation. Thus, the refrigerant charging hole 92 and the air outlet port 93 are temporarily sealed by carrying out such low-temperature vacuum pressurization treatment. At that time, the refrigerant charging hole 92 and the air outlet port 93 are closed by the sealing member 94.

In the meantime, a temperature at which vacuum deaeration is to be performed is preferably as low as about 20 degrees C, and a pressure at which the sealing member 94 is to be subjected to low- temperature pressurization deformation is preferably about 60 kg/cm².

As shown in Fig. 23 (B), the degassing grooves 114 enable the interior space 111 of the heat pipe 90 to be kept in fluid communication with the exterior even when the sealing member 94 is placed on the refrigerant charging hole 92 and the air outlet port 93, thereby enabling the degassing of the interior space 111 of the heat pipe 90. In the meantime, arrows shown in Fig. 22 (B) indicate degassing directions.

Those degassing grooves 114 serve to keep the interior space 111 of the heat pipe 90 communicated with the exterior not only when the sealing member 94 is placed on the refrigerant charging hole 92 but also when the sealing of the refrigerant charging hole 92 has proceeded to some extent so that they can be sealed by the sealing members 94 by the pressurization and heating after the low temperature vacuum heating treatment.

Next, after the low-temperature vacuum heating treatment, the sealing members 94 are further pressed from above (at 30-150 kg/ cm²) for about 10 minutes, for example, under a high temperature condition (from normal temperature (e.g., about 25 degrees C) to 180 degrees C), with a degree of vacuum being set to 0.5KPa, for example. As a result, the sealing members 94 are turned into plastic flow, and subjected to a high-temperature pressurization deformation so that the refrigerant charging hole 92 and the air outlet port 93 are still more firmly closed by the sealing members 94, as shown in Fig. 22(C).

In the meantime, a temperature at which the further pressing is to be performed is preferably about 120 degrees C, and a pressure at which the sealing member 94 is to be subjected to high- temperature pressurization deformation is preferably about 100 kg/ cm².

In other words, the sealing members 94 are tuned into plastic flow primarily by the pressurization, and secondarily by the heating, thus enabling the refrigerant charging hole 92 and the air outlet port 93 including the degassing grooves 114 to be sealed. After having sealed the refrigerant charging hole 92 and the air outlet port 93 by the sealing members 94, the heating and the vacuuming are stopped, and the pressurization by the press 116 is released, thus terminating these pressing, heating and vacuuming processes. As a result, as shown in Fig. 22 (C), the originally spherical sealing members 94 are turned into the shape of the refrigerant charging hole 92 and the air outlet port 93 by plastic flow so that they may substantially serve as a sealing plug, sealing up the interior space 111 of the heat pipe 90 to thereby make up a sealed space 112.

According to the heat pipe 90 of the foregoing structure, the refrigerant charging hole 92 and the air outlet port 93 each provided with the degassing grooves 114 are provided in the upper outside surface 91a of the upper member 91, and after charging the refrigerant M from the refrigerant charging hole 92, the spherical sealing member 94 is placed on the refrigerant charging hole 92 and the air outlet port 93, and then heating and pressing are applied to the sealing members 94 by the press 116, while reducing the pressure of the interior space 111. In the heat pipe 90, therefore, the sealing members 94 are turned into plastic flow and deformed to conform to the shape of the refrigerant charging hole 92 and the air outlet port 93, thus ensuring the sealing of the interior space 111 with the same being depressurized.

According to the manufacturing method (the refrigerant enclosing method) of the heat pipe 90 of the present invention, the two or more heat pipes 90 are arranged under vacuum, and the sealing member 94 is placed on the refrigerant charging hole 92 and the air outlet port 93 of each heat pipe 90, and then degassing as well as pressing and heating of the sealing members 94 can be carried out to the plurality of the heat pipes 90 at once so that all the sealing members 94 may be turned into plastic flow to enclose the refrigerant all at once. As a result, mass-productivity of the heat pipe 90 can be enhanced, leading to price reduction of the heat pipe 90, as compared to the conventional sealing method in which caulking is carried out one by one for each refrigerant charging opening.

Moreover, according to the foregoing heat pipe 90, the spherical sealing members 94 are turned into plastic flow so that they are deformed according to the shape of the refrigerant charging hole 92 and the air outlet port 93 to thereby serve as the sealing plugs, thus making the sealing members 94 less likely to protrude from the upper outside surface 91a of the heat pipe 90, preventing the flatness of the outer surface of the heat pipe 90 from being impaired by the sealing. As a result, it is possible to improve a degree of freedom when mounting the heat pipe to the inside of a mobile or small device.

Also, according to the foregoing heat pipe 90, the degassing grooves 114 are provided separately, said degassing groove 114 being formed by cutting out the inner circumference of the opening 113 of each of the refrigerant charging hole 92 and the air outlet port 93. Accordingly, the interior space 111 of the heat pipe 90 can be kept in fluid communication with the exterior thereof through the degassing grooves 114 not only when the sealing members 90 serving as the sealing plugs are being placed on the refrigerant charging hole 92 and the air outlet port 93 but also when the sealing members 94 have started melting and the sealing process has progressed to some extent. As a result, it is possible to ensure the degassing of the interior space 111 of the heat pipe 90, without sealing the refrigerant charging hole 92 and the air outlet port 93 by the sealing members 94.

Still also, according to the foregoing heat pipe 90, when sealing the refrigerant charging hole 92 and the air outlet port 93 with the sealing members 94, vacuum deaeration is performed through the degassing grooves 114, and thus, even though some hazardous component that causes the inside of the heat pipe 90 to corrode is present in the interior space 111, the air in the interior space 111 is removed through the degassing grooves 114, thus enabling the hazardous component to be removed together with the air from the interior space 111 reliably. As a result, it is possible to provide the heat pipe 90 of which the life-shortening due to internal corrosion can be prevented, with a reduced outgassing concentration.

In addition, according to the foregoing heat pipe 90, the sealing members 94 made from ductile metal are brought into plastic flow and deformed to thereby serve as the sealing plugs, and thus the degassing grooves 114 also can be closed reliably by the sealing members 94, whereby refrigerant M is completely enclosed within the interior space 111 of the heat pipe 90, with the refrigerant charging hole 92 and the air outlet port 93 being completely shut off from the exterior, without the leakage of the refrigerant M.

As is apparent from the foregoing, according to the heat pipe 90, the boiling point of the refrigerant drops because the sealed space 112 is brought under reduced pressure (e.g., about 0.5 KPa if the refrigerant is water), and thus the refrigerant turns into vapor more easily at a temperature of 50 degrees C or less (for example, about 30 to 35 degrees C) slightly higher than normal temperature.

Accordingly, according to the heat pipe 90, refrigerant M is allowed to evaporate with a slight amount of heat from the device to be cooled 13, and then the vapor is allowed to diffuse through the vapor diffusion flow paths 10 toward the peripheral portions 16 and 20, where the vapor is condensed and the refrigerant M thus liquefied is then allowed to pass through the capillary flow paths 11 due to the capillary phenomenon, and return to the center side. Such circulating action of the refrigerant M can be repeated easily and successively.

Moreover, according to the heat pipe 90, refrigerant M can evaporate at a temperature slightly higher than normal temperature so that the circulation of refrigerant M can be repeated successively, achieving heat homogenization, thus enabling the effective cooling of the device to be cooled 13.

Still moreover, according to the heat pipe 90, the cooling effect equivalent to that of the conventional heat pipes can be obtained without using a heat sink, thereby realizing the reduction of the number of components of the heat pipe 90 itself.

In addition, according to the heat pipe 90, on the upper outside surface 91 a of the upper member 91, the refrigerant charging hole 92 is provided in the vicinity of one of the diagonally opposite corners, while the air outlet port 93 is provided in the vicinity of the other thereof, thus facilitating the supply of the refrigerant M into the whole interior space 111 of the heat pipe 90.

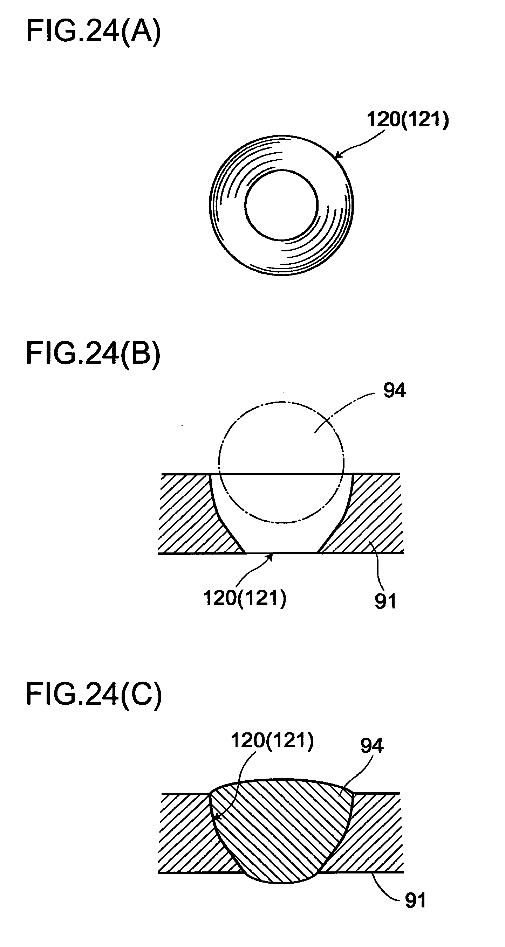

Although in the fourth embodiment, the refrigerant charging hole 92 and the air outlet port 93 are each provided with the four semicircular degassing grooves 114 formed in the inner circumference of the cylindrical opening 11, the present invention should not be limited thereto. For example, as shown in Fig. 24 (A) showing a planar structure of the refrigerant charging hole 92 or the air outlet port 93, and in Fig. 24 (B) showing a side sectional structure thereof, the refrigerant charging hole 92 and the air outlet port 93 may be formed in an inverted truncated cone shape such that the diameter of the opening becomes larger at an upper side, and becomes progressively smaller downward and minimum at a bottom side. In that case as well, as shown in Fig. 24 (C) showing the opening sealed by the sealing member 94, the spherical sealing member 94 is turned into plastic flow and deformed according to the shape of a refrigerant charging opening 120 and an air outlet port 121 to thereby substantially serve as the sealing plugs, enabling the reliable sealing of the interior space 111.

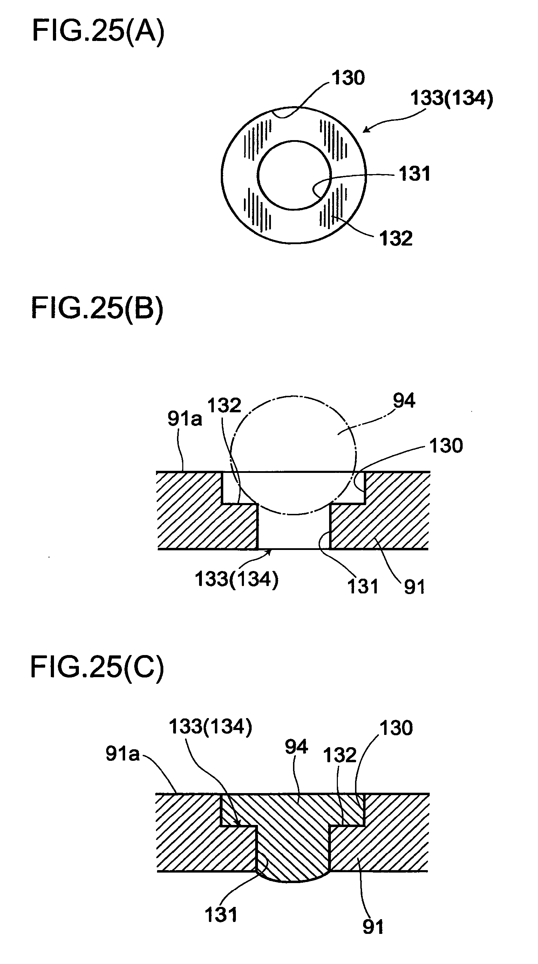

In an alternative form of the refrigerant charging opening and the air outlet port, as shown in Fig. 25 (A) showing a planar structure of a refrigerant charging opening 133 or an air outlet port 134, and in Fig. 25 (B) showing a side sectional structure thereof, the refrigerant charging opening 133 and the air outlet port 134 may be formed such that the opening may comprise: an upper section 130 of a short cylindrical shape, having a larger diameter; and a lower section 131 of a short cylindrical shape, having a smaller diameter; and a step section 132 formed therebetween to integrate the upper section 130 with the lower section 131.

In that case, as shown in Fig. 25 (C) showing the opening sealed by an another example of the sealing member 94, when the sealing member 94 is turned into plastic flow and has filled the lower section 131 completely, the remainder of the sealing member 94 is accommodated within the larger upper section 130, thus enabling the sealing member 94 to be prevented from protruding out of the upper outside surface 91a of the heat pipe 90. Thus, the upper outside surface 91 a of the heat pipe 90 can be formed flat even after sealing by the sealing member 94.

In the meantime, in any example shown in Fig. 24 (A), (B) and Fig. 25 (A), (B), the degassing grooves 114 may be provided separately like in the example shown in Fig. 23 (A) and (B). In those cases as well, the same effect can be obtained.

Although the refrigerant charging openings 37 and 92 and the air outlet ports 38 and 93 are provided as one or more refrigerant charging openings in the fourth embodiment, the present invention should not be limited thereto. For example, the refrigerant charging hole 92 and the air outlet port 93 may be formed integrally. Alternatively, there may be provided two refrigerant charging openings 92, one for use as a refrigerant charging opening, the other for use as an air outlet port.

## Claims

1. A heat pipe comprising:
an upper member, said upper member being tabular, having a concave portion on a lower surface;
a lower member, said lower member also being tabular, having a concave portion on an upper surface;
one or more intermediate plate members, said one or more intermediate plate members being tabular, provided between said upper member and said lower member, each intermediate plate member including a plurality of vapor diffusion flow paths extending in a planar direction, communicating with the concave portions of said upper and lower members to form a sealed space defined by said upper and lower members with said vapor diffusion flow paths and said concave portions being included therein;
a refrigerant enclosed in said sealed space; and
capillary flow paths formed through a portion of said one or more intermediate plate members except where said vapor diffusion flow paths are formed, said capillary flow paths extending vertically or both vertically and horizontally, communicating with the concave portions of said upper and lower members.

2. The heat pipe according to claim 1, wherein said intermediate plate members are more than one, each intermediate plate member having a through-hole formed therethrough, such that the through-holes of said intermediate plate members are overlapped only partially by stacking said intermediate plate members to define said capillary flow path having a planar cross-sectional area narrower than that of said through-hole.

3. The heat pipe according to claim 1, further comprising a plurality of projections integrally formed on an outer surface of at least one of said upper and lower members so that a device to be cooled may be mounted thereon.

4. The heat pipe according to claim 2, further comprising a plurality of projections integrally formed on an outer surface of at least one of said upper and lower members so that a device to be cooled may be mounted thereon.

5. The heat pipe according to one of claims 1 to 4, wherein said upper and lower members have a rectangular planar shape, respectively, while a device mounting section for mounting a device to be cooled thereon is arranged in the center of said heat pipe, with each of said vapor diffusion flow paths extending in an oblique direction relative to sides of said heat pipe.

6. The heat pipe according to one of claims 1 to 4, wherein said upper and lower members have a rectangular planar shape, respectively, while a device mounting section for mounting a device to be cooled thereon is arranged in the center of said heat pipe, with each of said vapor diffusion flow paths extending in a radial direction from said device mounting section.

7. The heat pipe according to claim 3 or 4, wherein joining projections are formed in a peripheral portion of each of said upper member, one or more intermediate plate members and lower member as well as from a peripheral portion of said device mounting section to a neighborhood thereof, so that said upper member, one or more intermediate plate members and lower member are joined directly to each other by hot pressing to said joining projections.

8. The heat pipe according to claim 5, wherein joining projections are formed in a peripheral portion of each of said upper member, one or more intermediate plate members and lower member as well as from a peripheral portion of said device mounting section to a neighborhood thereof, so that said upper member, one or more intermediate plate members and lower member are joined directly to each other by hot pressing to said joining projections.

9. The heat pipe according to claim 6, wherein joining projections are formed in peripheral portions of said upper member, one or more intermediate plate members and lower member as well as from a peripheral portion of said device mounting section to a neighborhood thereof, so that said upper member, one or more intermediate plate members and lower member are joined directly to each other by hot pressing to said joining projections.

10. A method for manufacturing a heat pipe, comprising the steps of:
preparing a lower member of a tabular shape, having a concave portion on an upper surface thereof; an upper member of a tabular shape, having a concave portion on a lower surface thereof; and one or more intermediate plate members provided between said upper member and said lower member, each intermediate plate member being of a tabular shape, including a plurality of vapor diffusion flow paths extending in a planar direction, communicating with the concave portions of said upper and lower members;
superimposing said members with one upon top of another;
applying hot pressing to joining projections, said joining projections being formed either in peripheral portions of said lower, upper and one or more intermediate plate members where said members are to be joined directly to each other, or in peripheral portions of said lower, upper and one or more intermediate plate members as well as from a peripheral portion of said device mounting section to a neighborhood thereof; and
joining said upper, lower and one or more intermediate plate members together directly relative to each other in positions where said joining projections are formed.

11. A heat pipe comprising:
an upper member, said upper member being tabular, having a concave portion on a lower surface;
a lower member, said upper member being tabular, having a concave portion on an upper surface;
one or more intermediate plate members, said one or more intermediate plate members being tabular, provided between said upper member and said lower member, each intermediate plate member including a plurality of vapor diffusion paths, communicating with the concave portions of said upper and lower members, said respective members being superimposed with one upon top of another to form a sealed space defined by said upper and lower members with said vapor diffusion flow paths and said concave portions being included therein;
one or more refrigerant charging openings formed through one of said upper and lower members, said charging openings allowing said sealed space to communicate with an exterior space;
a refrigerant enclosed in said sealed space; and
a sealing plug for sealing each of said refrigerant charging openings, said sealing plug being made from ductile metal.

12. The heat pipe according to claim 11, further comprising one or more degassing grooves formed on a peripheral inner surface of each of said refrigerant charging openings, wherein said degassing groove keeps an interior space communicated with an exterior space until each refrigerant charging opening is sealed fully by said sealing plug, while said degassing groove is sealed by said sealing plug when each refrigerant charging opening is sealed fully by said sealing plug.

13. The heat pipe according to claim 11, wherein each refrigerant charging opening has a larger diameter in an upper portion thereof than in a lower portion thereof, while a surface of said sealing plug for sealing each refrigerant charging opening is not protruded from an outer surface of the member formed with said refrigerant charging opening.

14. The heat pipe according to claim 12, wherein each refrigerant charging opening has a larger diameter in an upper portion thereof than in a lower portion thereof, while a surface of said sealing plug for sealing each refrigerant charging opening is not protruded from an outer surface of the member formed with said refrigerant charging opening.

15. The heat pipe according to any one of claims 1,2,3,4,8.9,11,12,13 and 14, wherein an interior of said sealed space is under reduced pressure.

16. A method for manufacturing a heat pipe, comprising the steps of:
preparing a lower member of a tabular shape, having a concave portion on an upper surface thereof; an upper member of a tabular shape, having a concave portion on a lower surface thereof; and one or more intermediate plate members provided between said upper member and said lower member, each intermediate plate member being of a tabular shape, including a plurality of vapor diffusion flow paths extending in a planar direction, communicating with the concave portions of said upper and lower members;
superimposing said members with one upon top of another;
applying hot pressing to joining projections, said joining projections being formed either in peripheral portions of said lower, upper and one or more intermediate plate members where said members are to be joined directly to each other, or in peripheral portions of said lower, upper and one or more intermediate plate members as well as from a peripheral portion of said device mounting section to a neighborhood thereof;
joining said upper, lower and one or more intermediate plate members together directly relative to each other in positions where said joining projections are formed;
supplying a refrigerant into a sealed space defined by said upper and lower members through one or more refrigerant charging openings formed through at least one of said upper and lower members, under reduced pressure; and
placing a ductile metallic body serving as a sealing plug in each refrigerant charging opening, and then applying pressure to said ductile metallic body to thereby provide said sealing plug for sealing each refrigerant charging opening.
